Europäisches Patentamt

European Patent Office

Office européen des brevets

(19)

(11) Publication number: **0 404 980 B1**

# EUROPEAN PATENT SPECIFICATION

(12)

(45) Date of publication of patent specification: **05.05.93**   (51) Int. Cl.⁵: **G01D 5/24**

(21) Application number: **89111779.8**

(22) Date of filing: **28.06.89**

(54) **Capacitance–type measuring method for absolute measurement of positions.**

(43) Date of publication of application:
**02.01.91 Bulletin 91/01**

(45) Publication of the grant of the patent:
**05.05.93 Bulletin 93/18**

(84) Designated Contracting States:
**CH DE GB LI SE**

(56) References cited:
**EP–A– 0 240 020**
**EP–A– 0 248 165**
**GB–A– 2 009 944**
**US–A– 4 429 307**

(73) Proprietor: **MITUTOYO CORPORATION**
**5–31–19, Shiba 5–chome**
**Minato–ku Tokyo 108(JP)**

(72) Inventor: **Andermo, Nils I.**
**5906–112th Place N.E.**
**Kirkland Washington 98033(US)**

(74) Representative: **Patentanwälte Grünecker,**
**Kinkeldey, Stockmair & Partner**
**Maximilianstrasse 58**
**W–8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates generally to capacitance – type measuring devices for making linear and angular measurements, and more particularly to a method for making absolute measurements of position in a capacitance – type measuring transducer described in the preamble part of claim 1.

Numerous capacitance – type measuring devices for making linear and angular measurements have been developed wherein two support members or scales, on which are respectively mounted arrays of discrete, capacitively coupled electrodes, are displaced relative to each other, and the relative positions of the two scales are determined by sensing the resulting change in the capacitance pattern created by the arrays of electrodes. Typically, the capacitance pattern is sensed by applying a plurality of periodic signals to one of the electrode arrays and measuring the shift in the signals resulting from the transfer to the other array of electrodes. Such measuring devices have a broad range of applications, from large – scale measuring devices such as three – dimensional coordinate measuring systems and numerically controlled finishing machines, to small – scale devices such as portable calipers, micrometers and the like.

Although capacitance – type measuring devices have become increasingly popular, they have here – tofore been subject to a number of disadvantages which have limited their wider application. A major source of disadvantages has been the fact that conventional capacitive – type measuring devices have typically only been capable of making relative, and not absolute, measurements. That is, measurements are typically made by sensing the relative change in position of the scales with respect to a reference position, which requires a continuous sensing of the change in the capacitance pattern created by the electrode arrays so that repetitions of the pattern can be counted. Further, relative measurements require that a new reference or zero position be established before every measurement, which makes such devices relatively incon – venient to use.

In addition, the rate at which the scales of relative measurement devices can be displaced with respect to each other is limited by the speed of the signal processing which can be accomplished. On the one hand, if the scales are displaced too quickly, miscounting can occur. On the other hand, increasing the allowable scale displacement speed entails the use of high frequency signals and sophisticated signal processing circuitry, which substantially increases the cost of the measurement devices.

The ability to make absolute measurements of scale position, i.e., measurements based solely on the respective final measurement positions of the scales, obviates the various problems discussed above. A zero or reference setting for the scales can be established during assembly of the measuring device, and there is no need to adjust the setting during subsequent measurements. Nor are there any limitations on the displacement speed of the scales, since the capacitance pattern between the scale electrodes needs to be sensed only at the final measurement position of the scales. Further, the power source needs to be connected only when the final measurement position is to be measured, which greatly reduces the power consumption and allows even small – capacity power sources, such as solar batteries, to be employed.

The present inventor has previously developed a capacitive – type measuring device capable of making absolute measurements, which is shown in Figures 10 and 11 of GB – A – 2 009 944. This device utilizes separate first and second pairs of transmitter/receiver electrode arrays arranged in side – by – side relation – ship. The relationship of the pitch of the transmitter electrodes to the pitch of the receiver electrodes is the same in each array pair, but the respective transmitter/receiver electrode pitches in the two array pairs differ slightly. Two separate n – phase signals are applied to the respective transmitter electrodes of the two array pairs and two independent signals $V_1$ and $V_2$ are obtained (via associated transfer and detector elec – trodes) from the respective receiver electrodes in each array pair. An absolute measurement value is derived by measuring the phase difference between the two signals $V_1$ and $V_2$.

However, the utility of the measuring device is limited. For example, because the absolute measure – ment value calculation is based on two independent measurements, slight errors in either measurement accumulate and can result in large position measurement errors. Consequently, the respective signal processing circuits must have precisely matched performance characteristics in order for accurate absolute position measurements to be obtained. Further, if the two measurements are not made at precisely the same time, even very slight displacement of one support member relative to the other between the times the two measurements are taken can cause very large errors in the position measurement.

In addition, the physical requirement of two separate pairs of electrode arrays in the measuring device limits its application in hand measuring tools, which must have a compact size. Further limiting its application in portable measuring devices is the increased power consumption caused by the requirement for duplicate signal processing circuitry.

From EP – A – 0248165, a capacitance type transducer for measuring positions is known. In the transducer, the relative positions of a first scale and a second scale which are displaced relative to each other are measured as absolute values. The first scale is provided with a number of transmitting electrodes which are supplied with AC signals of different phases and the second scale is provided with receiving electrodes which are coupled capacitively with the transmitting electrodes. Furthermore, there are provided second transmitting electrodes provided which are electrically connected by coupling electrodes to the receiving electrodes provided on the second scale. Between both electrodes on the second scale, specified deflections are provided and the relative positions of both scales can be measured as absolute values by means of these deflections. To determine relative positions of the first scale with respect to the second scale, coarse, medium and fine measurements can be performed by comparing the received signal levels with the phases of the AC signals transmitted and arithmetical processing.

In accordance with the present invention, a method is provided for carrying out the coarse, medium and fine measurements in a capacitance type transducer which is described in the preamble part of claim 1, the method comprising the steps as defined in the characterizing part of claim 1.

The present invention will be described with reference to the drawings, wherein like elements have been denoted throughout the figures with like reference numerals, and wherein:

Fig. 1 is a partly schematic, partly diagrammatic view of a first embodiment of an absolute measurement caliper constructed in accordance with the present invention.

Fig. 2A is a partial top elevation view of one portion of a second embodiment of a transducer constructed in accordance with the present invention.

Fig. 2B is a partial top elevation view of another portion of the transducer shown in Fig. 2A.

Fig. 3 is a partial perspective view of one portion of a third embodiment of a transducer constructed in accordance with the present invention.

Fig. 4 is a diagrammatic partial view of a further embodiment of an absolute measurement caliper constructed in accordance with the present invention.

Fig. 5 is a schematic block diagram of an exemplary embodiment of the measuring circuit portion of a caliper constructed in accordance with the present invention.

Fig. 6 is a table showing the relation of control signals for the transducer excitation signal generator included in the measuring circuit of Fig. 5.

Fig. 7 is a table showing the relation of control signals for the transducer output signal combiner included in the measuring circuit of Fig. 5.

Figs. 8A − 8E are flow charts of programs performed by the microprocessor controller included in the measuring circuit of Fig. 5.

Fig. 9 is a graph showing the spatial relationship with respect to the measurement axis of transducer outputs produced in response to group phase excitation signal combinations generated by the measuring circuit of Fig. 5.

The present invention will be described as implemented in portable, hand − held linear measurement calipers. However, it will be appreciated by those of ordinary skill in the art that the present invention is not limited to such measuring devices, and can be implemented in a broad range of large − scale and small − scale measuring devices for making both linear and angular measurements.

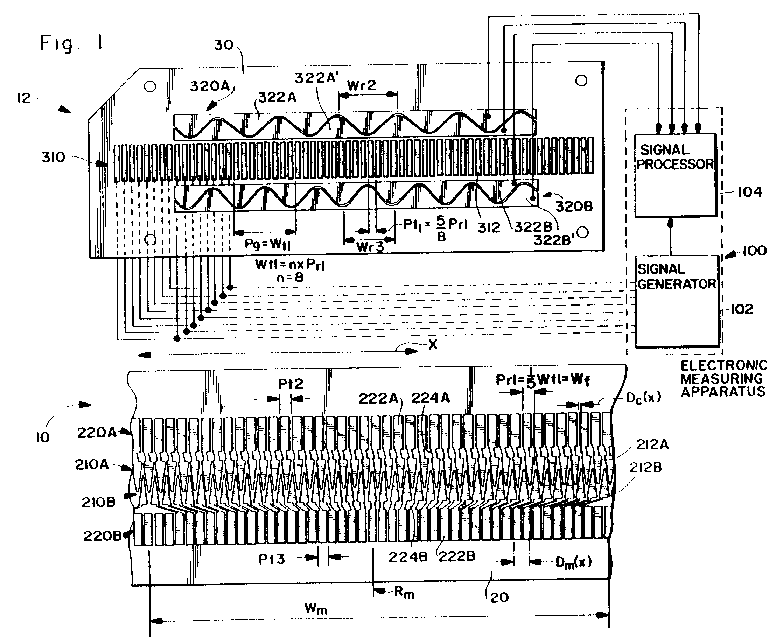

Embodiments of a capacitive − type linear absolute measurement caliper 10 constructed in accordance with the present invention are shown in Figs. 1 − 2 which are adapted for making coarse, medium and fine resolution absolute measurements of a measurement position, thereby permitting highly precise absolute measurements to be obtained over a wide measuring range. Caliper 10 basically comprises a capacitive transducer 12 and electronic measuring apparatus 100 for applying electrical excitation signals to trans − ducer 12 and processing the resultant output signals produced by transducer 12 to ascertain a given measurement position. Transducer 12 comprises a linear first scale or support member 20, and a linear second scale or support member 30 slidably mounted on support member 20 for longitudinal axial displacement with respect to member 20 so as to define a measurement axis X. As is conventional, support members 20 and 30 advantageously are provided with extending caliper arms (not shown) which permit dimensional measurements of an object to be made. The gap between support members 20 and 30 advantageously is on the order of 0.05 mm (0.002 inch).

Disposed on the respective support members in respectively opposing relationships to each other, and in relative alignment with the measurement axis and the respective caliper arms, are seven electrode arrays, generally denoted 210A, 210B, 220A, 220B, 310, 320A and 320B. As is described in more detail hereinbelow, a plurality of periodically varying signals are applied to electrode array 310 in predetermined sequences and the resulting signals produced by different electrical configurations of electrode arrays 320A and 320B are sensed in dependence on the type (coarse, medium or fine) of measurement. Accordingly, for convenience of description, the electrodes of array 310 will be described as first transmitter electrodes, the electrodes of arrays 210A and 210B will be described as first receiver electrodes, the electrodes of arrays 220A and 220B will be described as second and third transmitter electrodes, respectively, and the electrodes of arrays 320A and 320B will be described as second and third receiver electrodes, respectively, in conformance with the respective functions of the electrode arrays in the transmission of signals from array 310 to arrays 320A and 320B.

First receiver electrode arrays 210A and 210B disposed on support member 20 are identical, interleaved arrays which advantageously are formed, as shown, by two interleaved rows of discrete, electrically isolated first receiver electrodes 212A and 212B having identical, uniform geometries. Electrodes 212A are spaced apart from each other, and electrodes 212B are similarly spaced apart from each other, along the measurement axis by a uniform pitch $P_{r1}$ (corresponding edge to corresponding edge distance) defining a desired first receiver electrode wavelength $W_{r1}$ (scale or fine wavelength $W_f$).

First transmitter electrode array 310 disposed on support member 30 advantageously comprises a row of discrete first transmitter electrodes 312 disposed in opposing alignment with electrode arrays 210A and 210B so as to be capacitively coupled to differing portions of the electrode arrays 210A and 210B depending on the relative positions of support members 20 and 30.

The relative spacing of the electrodes in the respective electrode arrays 310 and 210A/210B is based on several considerations. Coarse resolution measurements are made in accordance with the present invention by applying N periodically varying excitation signals in numerical sequence to groups of N first transmitter electrodes 312, where N is equal to or greater than three, so as to create an electric field with a predetermined varying voltage distribution over a transmitter wavelength $W_{t1}$ corresponding to the pitch Pg (defined as the edge-to-edge distance between the leading electrodes in adjacent groups) of the first transmitter electrode groups. The first receiver electrode arrays 210A/210B need to have an electrode density relative to the first transmitter electrode array 310 sufficient to adequately sample the first transmitter electrode field over one transmitter wavelength $W_{t1}$ so that the voltage distribution over the portion of the first receiver electrode arrays 210A/210B capacitively coupled to the first transmitter electrode array 310 is substantially the same as the voltage distribution over the first transmitter array. Consequently, the density of electrode distribution in first receiver electrode arrays 210A/210B should be at least three electrodes 212A/212B over a distance corresponding to the transmitter wavelength $W_{t1}$. The pitch $P_{t1}$ of first transmitter electrodes 312 is thus determined in part by the desired fine wavelength $W_f$ andthe requirement that at least three first receiver electrodes 212A/212B be disposed within a transmitter wavelength $W_{t1}$.

In addition, in order to make fine measurements using the same electrode arrays and signal processing circuitry, the first transmitter electrodes 312 are positioned within each electrode group so as to respectively occupy N group positions which each represent a different relative fine wavelength segment position obtained by dividing the transmitting wavelength $W_{t1}$ into a number of intervals corresponding to a fine wavelength $W_f$, and dividing each interval into N equal segments. This first transmitter electrode arrange-ment allows the measurement direction width of the individual transmitter electrodes to be significantly increased relative to the scale wavelength.

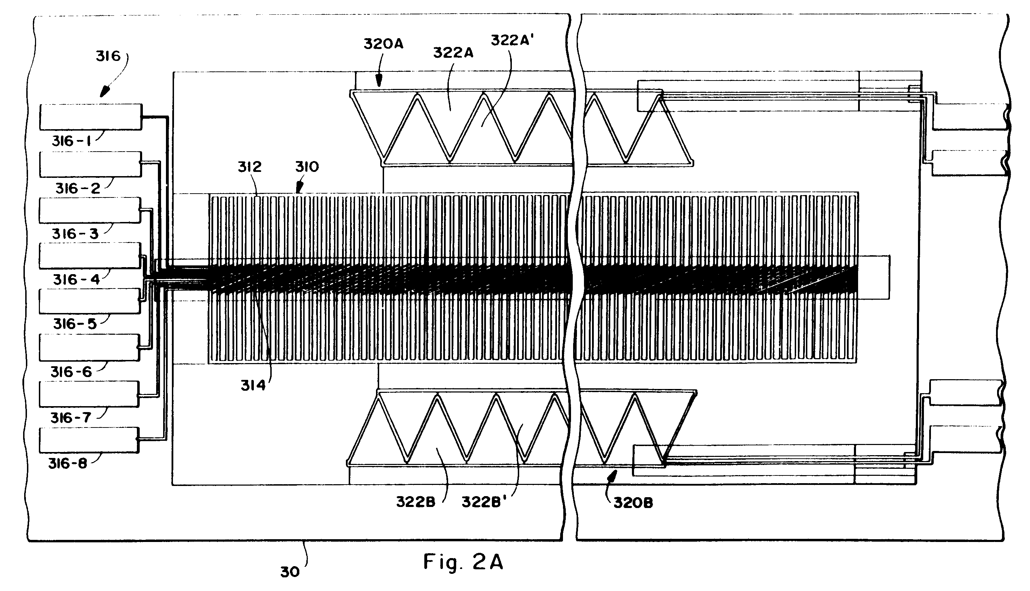

As shown in Fig. 2A, the corresponding first transmitter electrodes 312 in each group advantageously are electrically interconnected by connecting elements 314, and the electrodes 312 in one of the end groups are connected to corresponding transducer input terminals 316 for applying the excitation signals to the respective electrodes 312 in each electrode group in a predetermined order according to the order in which the signals are connected to terminals 316.

Referring to Figs. 1-2, second transmitter electrode array 220A disposed on support member 20 comprises, as shown, a row of discrete second transmitter electrodes 222A adjacent to, and in relative alignment with electrode array 210A on one side thereof. Each of the second transmitter electrodes 222A is electrically connected via a connecting electrode 224A to a corresponding one of the receiver electrodes 212A such that each second transmitter electrode 222A is spatially offset or displaced from the corresponding first receiver electrode 212A relative to the measurement axis by an amount $D_c(x)$ which is a predetermined function of the position of the second transmitter electrode 222A relative to a reference position $R_c$ on the measurement axis (not shown); and further such that the offset between the transmitter electrodes 222A and the corresponding receiver electrodes 212A does not change by an amount exceeding the transmitting wavelength $W_{t1}$ over a predetermined maximum coarse measurement range or wavelength $W_c$ (not shown). Advantageously, the degree of electrode offset is a linear function which increases as the distance of a second transmitter electrode 222A relative to the reference position increases, but it will be appreciated that the relationship between the electrode offset and the relative position of a second transmitter electrode can be any desired nonlinear function. Advantageously, second transmitter electrodes 222A are spaced from each other by a uniform pitch $P_{t2}$ different than pitch $P_{r1}$, as shown, to provide a linear relationship between the electrode offset and second transmitter electrode relative position. With such an arrangement, the degree of offset $D_c(x)$ has the following relationship:

$$D_c(x) = (P_{t2} - P_{r1}) f(x)$$

$$f(x) = \frac{x}{P_{r1}}$$

$$D_c(x) = \left( \frac{P_{t2} - P_{r1}}{P_{t2}} \right) x$$

where x denotes the distance of a second transmitter electrode from the reference position.

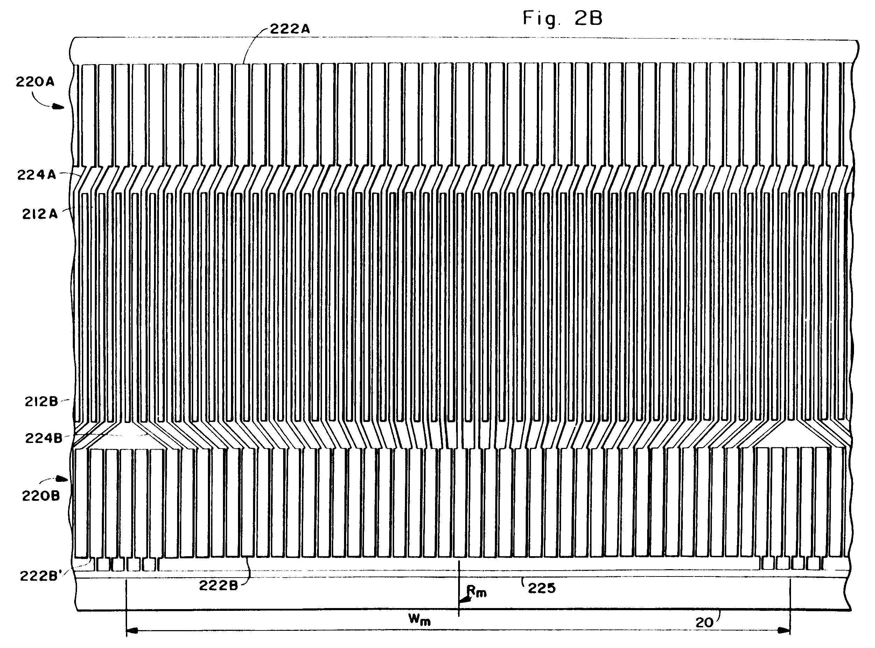

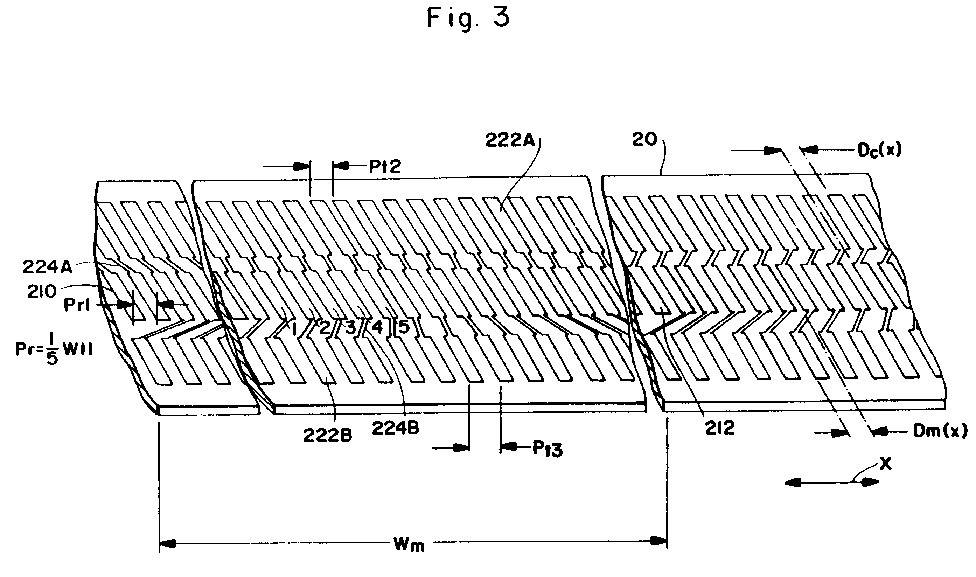

It will also be appreciated that the reference position $R_c$ to which the degree of electrode offset is related can be located either at one end of the coarse wavelength $W_c$ of the caliper, as in the embodiment of Figs. 1 and 2, or at an intermediate location, such as, for example, the mid−point, of the coarse wavelength $W_c$, as in the embodiment of Fig. 3. It will be appreciated that, in the arrangement of Figs. 1 and 2, the degree of electrode offset is unique for each electrode pair, while in the arrangement of Fig. 3, second transmitter electrodes which are symmetrically disposed with respect to the reference position $R_c$ have the same degree of offset, but in opposite directions relative to the measurement axis, as shown. Thus in the embodiments of Fig. 3, the offset $D_c(x)$ varies between $+ \frac{1}{2}$ of the transmitter wavelength $W_{t1}$ and $- \frac{1}{2}$ of the wavelength $W_{t1}$. An advantage of the symmetrical offset configuration of the Fig. 3 embodiment is that the maximum offset $D_c(x)$ is limited, which reduces the amount of slanting and the length of connecting electrodes 224, thus facilitating manufacture.

Third transmitter electrode array 220B disposed on support member 20 comprises, as shown, a row of discrete third transmitter electrodes 222B adjacent to, and in relative alignment with first receiver electrode array 210B on the side opposite from second transmitter array 220A. Groups of receiver electrodes 212B are electrically connected to corresponding groups of transmitter electrodes 222B via connecting electrodes 224B as shown. Within each group of interconnected first receiver electrodes and third transmitter electrodes, the third transmitter electrodes 222B are spatially offset from the associated first receiver electrodes 212B to which they are connected in the same manner as the second transmitter electrodes 222A and first receiver electrodes 212A, i.e., the amount of offset $D_m(x)$ in each group is a predetermined function (linear or non−linear) of the position of the third transmitter electrode 222B relative to a reference position $R_m$ on the measurement axis within the group, and the change in offset $D_m(x)$ over the measuring distance, i.e., medium wavelength $W_m$, spanned by each group of third transmitter electrodes 222B is equal to the transmitting wavelength $W_{t1}$. Advantageously, as shown, the group reference position $R_m$ is located at the center of each group, and the offset $D_m(x)$ within each group varies symmetrically with respect to the reference position between $+ \frac{1}{2}$ of the transmitter wavelength $W_{t1}$ and $- \frac{1}{2}$ of the wavelength $W_{t1}$. Additionally, the medium wavelength should preferably have a length that is an integral number of transmitting wavelengths. The groups are repeated with a pitch equal to the medium wavelength $W_m$.

Advantageously, the coarse wavelength $W_c$ should be an integral multiple of the medium wavelength $W_m$, and the medium wavelength $W_m$ should be an integral multiple of the fine wavelength $W_f$. Additionally, the medium wavelength $W_m$ should have a length which is an integral multiple of the transmitter wavelength $W_{t1}$. A coarse resolution measurement needs to determine in which medium wavelength the measurement position is located, and a medium resolution measurement needs to determine in which fine wavelength the measurement position is located. Consequently, the accuracy of a medium measurement must be better than one fine wavelength, and the accuracy of a coarse measurement must be better than one medium wavelength.

Accordingly, the relationships between the coarse, medium and fine wavelengths $W_c$, $W_m$ and $W_f$ should be selected to provide a good margin of accuracy. For example, in the embodiment of Fig. 2, with N equal 8, $W_c = 40W_m$ and $W_m = 40W_f$, an interpolation resolution for coarse and medium measurements of 1/320 would allow the coarse measurement to determine measurement positions within 1/8 of a medium wavelength, and the medium measurement would be able to determine positions within 1/8 of a fine wavelength. This is a very good margin to the maximum allowed error of less than one wavelength. In a practical design $W_f = 1.024$ mm, and the fine interpolation resolution is $W_f/512$, or 2 microns. The total absolute measurement range is thus 40 x 40 x 1.024 mm = 1638 mm = 1.64 meters, with a resolution of 2 microns over the entire range.

Advantageously, third transmitter electrodes 222B are uniformly spaced from each other by a pitch $P_{t3}$, such that the offset $D_m(x)$ for a third transmitter electrode is a linear function of the relative position of the electrode within the group. As shown in Figs. 1 and 3, respectively, the pitch $P_{t3}$ may be such that the distance spanned by a group of third transmitter electrodes (the medium wavelength $W_m$) is less than (Fig. 1) or more than (Fig. 3) the distance spanned by the associated group of first receiver electrodes 212B to which the third transmitter electrodes are connected. In the case of the Fig. 1 arrangement, it will be appreciated that every first receiver electrode 212B can be connected to a corresponding third transmitter electrode 222B, but that not every third transmitter electrode can be connected to a corresponding first receiver electrode. It will also be appreciated that the converse is true in the case of the Fig. 3 arrangement. At least in the case of the Fig. 1 arrangement, it has been found to be desirable to connect to a grounded conductor 225 (Fig. 2) those transmitter electrodes 222B′ which are not connected to receiver electrodes 212B.

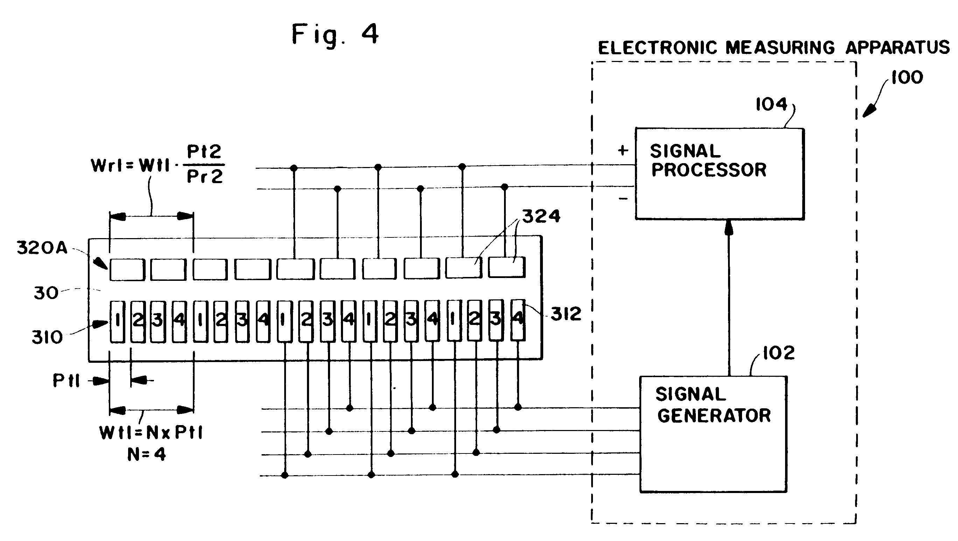

Second receiver electrode array 320A disposed on support member 30 advantageously comprises two second receiver electrodes 322A, 322A′ having complementary configurations which are disposed adjacent each other and in opposing alignment with second transmitter electrode array 220A. As shown, electrodes 322A, 322A′ have an elongate, periodically varying shape relative to the measurement axis, and the effective length of electrodes 322A, 322A′ is an integral multiple of the transmitter wavelength $W_{t1}$. From the standpoint of signal processing, electrodes having a sinusoidally varying shape, as shown in Fig. 1, are preferred. However, a triangular configuration, as shown in Fig. 2, or a rectangular configuration can also be used. One form of rectangular configuration is shown in Fig. 4, wherein second receiver electrode array 320 comprises a row of discrete rectangular electrodes 324 which are disposed on support member 30 in opposing alignment with second transmitter electrode array 220A. Electrodes 324 have a uniform pitch and are connected alternately as positive and negative inputs to the signal processing circuitry 104, as shown. The electrodes 324 thus collectively have a periodic configuration relative to the measurement axis, with a predetermined wavelength $W_{r2}$ as described more fully hereinbelow.

When N incrementally different periodically varying signals (or a group phase combination of signals as described hereinbelow) are applied in numerical sequence to each group of N first transmitter electrodes 312 according to the respective physical positions of corresponding ones of the electrodes in the group, the resultant electric field distribution over the first transmitter electrodes 312 has a wavelength $W_t$, and this field distribution is capacitively coupled to the first receiver electrodes 212A, and thereafter via connecting electrodes 224 to the second transmitter electrodes 222A with an offset $D_c(x)$ along support member 20 which varies according to the distance of each second transmitter electrode from the reference position $R_c$. The geometric structure of second receiver electrodes 322A and 322A′ (324), when the outputs thereof are connected differentially, functions as a spatial filter to detect the electric field component which is dependent on the second transmitter electrode offset $D_c(x)$, which offset is correlated to the relative positions of the support members by reason of the relationship of the offset to a predetermined reference position on support member 20, as described hereinabove. In the preferred embodiments wherein the offset $D_c(x)$ is a linear function, this can be readily accomplished by configuring the second receiver electrodes so as to have a periodicity or receiving wavelength $W_{r2}$ that detects the electric field component having a wavelength of one transmitter wavelength $W_{t1}$ normalized for the difference in pitch between the first receiver electrodes 212A and the second transmitter electrodes 222A. That is, the second receiver electrodes are configured so as to sense the electric field pattern over a receiving wavelength $W_{r2}$ having the following relationship to the transmitting wavelength:

$$W_{r2} = W_{t1} (P_{t2}/P_{r1}).$$

Third receiver electrode array 320B is configured similarly to electrode array 320A and is disposed in opposing alignment with third transmitter electrode array 220B. In particular, the second receiver electrodes 322B of array 320B are configured similarly to the electrodes of array 320A so as to sense the electric field pattern produced by the third transmitter electrodes 222B over a receiving wavelength $W_{r3}$ having the following relationship to the transmitting wavelength:

$$W_{r3} = W_{t1} (P_{t3}/P_{r1}).$$

As shown in Fig. 3, a single array 210 of first receiver electrodes 212 may advantageously be employed in lieu of the dual arrays 210A and 210B shown in Fig. 1. In the embodiment of Fig. 3, second transmitter electrodes 220A are connected to one end of first receiver electrodes 212, and third transmitter electrodes 220B are connected to the opposite end of first receiver electrodes 212, as shown. In addition, as shown in

6

Fig. 1, the first receiver electrodes advantageously may have a sinus – shaped configuration, such that the space between the electrodes forms a substantially full – wave sinusoidal curve extending parallel to the measurement axis.

In the fine measurement mode, the output terminals of second receiver electrodes 322A and 322A′ are electrically connected together. Consequently, electrode array 320A effectively functions as a unitary rectangular electrode extending over an integral number of transmitter wavelengths $W_{t1}$. Similarly, the output terminals of third receiver electrodes 322B, 322B′ are electrically connected together to also form an effective unitary rectangular electrode 320B extending over an integral number of transmitter wavelengths. A signal coupled from a first transmitter electrode 312 through the first receiver electrodes 212A and the associated second transmitter electrodes 222A to the combined second receiver electrode 320A will vary periodically as a function of the displacement x between the support members 20 and 30, relative to a reference position of the two support members, with a wavelength equal to the wavelength $W_{r1}$ of the first receiver electrode array 210A.

Similarly, a signal coupled from a first transmitter electrode 312 through the second receiver electrodes 212B and the associated third transmitter electrodes 222B to the combined third receiver electrode 320B will follow a similar periodic function 180 degrees out of phase to the signal produced by the combined second receiver electrode 320A.

The shape of these signal transfer functions between a first transmitter electrode and the fine mode configurations of the second/third receiver electrodes 320A/320B is dependent on the shapes of the first transmitter and first receiver electrodes. If the respective electrodes are rectangular in shape, the transfer function is a composite of triangular waveshapes for small gaps between the support members 20 and 30, and becomes sinusoidal as the gap increases. By making the first receiver electrodes sinusoidal in shape, as shown in Fig. 1, a sinusoidal transfer function is obtained independent of the gap dimension between the support members.

For a first one of the first transmitter electrodes, the above described fine mode transfer function, $T_{f1}$, can be mathematically expressed as:

$$T_{f1} = C_{fo} + C_f \sin\left(\frac{2\pi x}{W_f}\right)$$

where $C_{fo}$ = a constant capacitance value and $C_f$ = the amplitude of a variable capacitance value.

For a second one of the first transmitter electrodes, spaced a distance d (in the X – axis measurement direction) from the aforementioned first one of the first transmitter electrodes, the fine mode transfer function $T_{f2}$ can be expressed as a function of d relative to the $T_{f1}$ transfer function as follows:

$$T_{f2}(d) = C_{fo} + C_f \sin\left(\frac{2\pi(x-d)}{W_f}\right)$$

With the spacing d between the first transmitter electrodes selected as described hereinabove and in applicant s aforementioned copending application incorporated by reference, the first transmitter electrodes in a group of N electrodes are distributed over several fine wavelengths $W_f$, and the spacing $d_n$ between the first one and the nth one of the first transmitter electrodes in a group can be defined as:

$$d_n = n(W_f/N) + (M_n)(W_f)$$

where $M_n$ is an integer corresponding to the scale wavelength interval in which the nth electrode of the group is located.

For fine measurements, the factor $M_n$ can have any integer value because:

$$\sin(v + M2\pi) = \sin(v) \text{ if } M = \text{integer.}$$

A transfer function for the first transmitter electrode in each "phase" position within the group can thus be defined independently of M as:

7

$$T_n = C_{fo} + C_f \sin (2\pi(\tfrac{x}{W_f} - \tfrac{n}{N})).$$

This means that the N first transmitter electrodes in a group constitute N "phase" electrodes having sinusoidal transfer functions that are phase-shifted with respect to each other by 360/N degrees.

In the coarse and medium measurement modes, the outputs of the second and third receiver electrodes are connected differentially, i.e., the coarse measurement signal which is processed is the difference of the signals from second receiver electrodes 322A and 322A', and the medium measurement signal which is processed is the difference of the signals from third receiver electrodes 322B and 322B'. Referring specifically to the coarse measurement mode (the medium measurement mode description is analogous), for the case of second receiver electrodes configured so as to be separated from each other by a sinusoidal dividing line, as shown in Fig. 1, the capacitance between a second transmitter electrode 222A and second receiver electrode 322A is defined as a function of the relative displacement x between the support members as:

$$C'(x) = C_{co} + C_c \sin (2\pi(\tfrac{x}{W_{r2}} - \tfrac{n}{N})),$$

where $C_{co}$ = a constant capacitance value and $C_c$ = the amplitude of a variable capacitance value.

For the complementary second receiver electrode 322A', the corresponding capacitance function is defined as:

$$C''(x) = C_{co} - C_c \sin (2\pi(\tfrac{x}{W_{r2}} - \tfrac{n}{N}))$$

Differentially combining the capacitance functions produces

$$C(x) = C'(x) - C''(x) = 2C_c \sin (2\pi \tfrac{x}{W_{r2}} - \tfrac{n}{N})).$$

The transfer function for a signal from a first one of the first transmitter electrodes 312, via the first receiver electrodes 212A and the second transmitter electrodes 222A, to the second receiver electrodes 922A, 322A' is a combined function of the fine wavelength modulation produced by the first receiver electrodes, and the above defined capacitance functions:

$$\begin{aligned}
T_{c1}(x) &= (C_{fo} + C_f \sin (\tfrac{2\pi x}{W_f})) (C_{co} + C_c \sin (\tfrac{2\pi D(x)}{W_c})) - \\
&\quad (C_{fo} + C_f \sin (\tfrac{2\pi x}{W_f})) (C_{co} - C_c \sin (\tfrac{2\pi D(x)}{W_c})) = \\
&\quad (C_{fo} + C_f \sin (\tfrac{2\pi x}{W_f})) (2 C_c \sin (\tfrac{2\pi D(x)}{W_c})).
\end{aligned}$$

A second one of the first transmitter electrodes that is N/2 phase positions away from the aforementioned first one of the first transmitter electrodes will have both its fine and coarse sinus functions inverted, and its transfer function to the second receiver electrodes will be:

$$T_{c2}(x) = -(C_{fo} - C_f \sin (\tfrac{2\pi x}{W_f})) (2C_c \sin (\tfrac{2\pi D(x)}{W_c})).$$

Supplying the second one of the first transmitter electrodes with a signal that is the inverse of the signal supplied to the first one of the first transmitter electrodes produces the following resultant transfer function for the combination of the two first transmitter electrodes:

$$T_C(x) = T_{C1}(x) - T_{C2}(x) =$$
$$4(C_{fo})(C_C)\left(\sin\left(\frac{2\pi D(x)}{W_C}\right)\right).$$

The combined transfer function is thus independent of the fine wavelength modulation of the first receiver electrodes, and is dependent solely on the offset D(x) between the first receiver electrodes 212 and the associated second transmitter electrodes 222A, which dependence can be used to make coarse position measurements.

From the foregoing, it will be appreciated that the transducer electrode arrangement of the present invention can be utilized as a spatial filter, the filter function of which is readily alterable by changing its geometry through different electrical connections of the second receiver electrode outputs, to extract the desired component of the transducer geometry (either the fine wavelength modulation of the first receiver electrodes, or the adjusted transmitter wavelength signal distribution over the second transmitter electrodes indicative of the offset D(x)); and to reject the other component.

As noted hereinabove, the second and third receiver electrodes 322A, 322A′ and 322B and 322B′ can have different configurations, with the result that the dividing line between the associated electrodes of each electrode array can be other than sinusoidal, e.g., triangular or rectangular. Such alternative electrode arrangements will also provide the spatial filtering described hereinabove, and in general will do so as long as the transfer function between the second transmitter electrodes and the second receiver electrodes satisfies the condition that:

$$C(x) = C(x - W_{r2}/2)$$

It will also be appreciated that the spatial positions of the respective transducer output signal waveforms relative to a reference position are also dependent on the relative positions of the transducer support members 20 and 30 with respect to each other, which is the basic relationship that enables the measurement position to be determined by measuring temporal signal phase shifts.

In accordance with the present invention, absolute position measurements are derived from a combination of at least a coarse resolution measurement and a fine resolution measurement based on the foregoing principles. Advantageously a combination of a coarse, a medium, and a fine resolution measurement are utilized to obtain precise absolute measurements over an extended measuring range. Multiple measurements are obtained from the same electrode arrays by applying excitation signals in predetermined sequences or phase combinations to the first transmitter electrodes and connecting the second/third receiver electrode outputs to provide the appropriate spatial filtering according to the different measuring modes. The geometrical arrangement of the first and second/third transmitter electrodes is such that it is possible to obtain N distributed phase positions for a capacitance function having a fine wavelength; and also N distributed phase positions having a longer wavelength which extends over several fine wavelengths, and which carries coarse and medium position information via the respective offsets $D_c(x)$ and $D_m(x)$ between the first receiver electrodes and the second and third transmitter electrodes, respectively.

The different transfer functions described above are essentially capacitance functions, and the absolute position within each measuring wavelength $W_c$, $W_m$ and $W_f$ can, for each measuring mode (coarse, medium and fine), be measured with a number of different, previously known circuits for capacitive position measurements. Examples include the circuit described in applicant s aforementioned copending application incorporated herein by reference; and the circuits described in applicant s aforementioned U.S. Patent No. 4,420,754, which is hereby incorporated herein by reference. Such circuits, which are based on continuous excitation of the transmitter electrodes with cyclic signals of different phase positions, evenly distributed over the N inputs, and a receiver and evaluation circuit based on measurement of the relative phase position of the resulting composite signal, can be readily used with the following qualifications:

a) If the selected transducer electrode geometry is one that uses the same excitation signal sequence connection for all measuring modes, coarse, medium and fine measurements can be done concurrently by three parallel circuits of the above mentioned kind, and the absolute position value can be calculated from the output data from those measurements.

b) If the selected transducer electrode geometry is one that requires different excitation signal connection sequences for fine measurements and for medium/coarse measurements, the measurements must be multiplexed in time between the measurement modes.

c) If the three measuring modes coarse, medium and fine are multiplexed sequentially through the same measuring circuit, sufficient time must be allowed, for each measuring mode, for the signals to obtain a steady state condition (allow for time constants in filters and integrators) before a measurement value is taken.

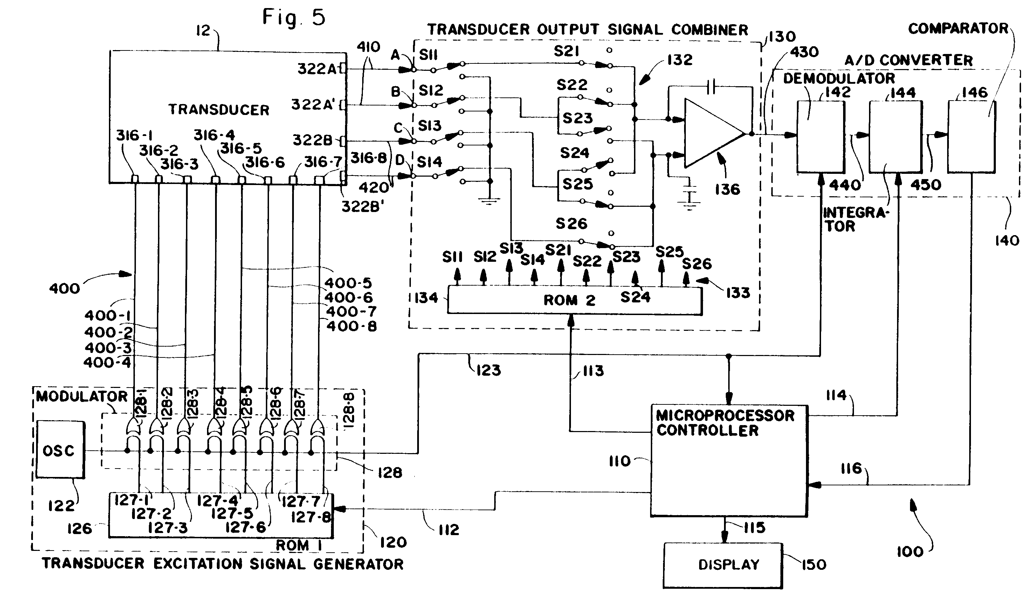

A preferred embodiment of electronic measuring apparatus 100 is shown in Fig. 5 which has the advantages of being faster than the aforementioned continuous signal phase measurement method, and being able to multiplex between measurement modes through a common electronic measuring circuit without the need for settling time between the three modes. In general the apparatus of Fig. 5 measures ratios of transducer output signals produced by different "group phase" combinations of excitation signals in each measuring mode with a dual ramp analog − to − digital (A/D,1 conversion method.

For purposes of clarity, the following description will be with reference to an exemplary embodiment of transducer 12 having an electrode configuration as shown in Fig. 2 and the following parameters:

Wavelengths:

$W_f$ = 1.024 mm

$W_m$ = 40 $W_f$ = 40.096 mm

$W_c$ = 40 $W_m$ = 1638.4 mm

First transmitter electrode pitch $P_{t1}$ = 5/8 ($W_f$)

Number of excitation signal "group phase" combinations N = 8

Excitation signal connection sequence for each group of N first transmitter electrodes:

Coarse/Medium measurement mode: 1 − 2 − 3 − 4 − 5 − 6 − 7 − 8

Fine Measurement mode: 1 − 6 − 3 − 8 − 5 − 2 − 7 − 4

As shown, the electronic measuring apparatus of Fig. 5 comprises a microprocessor controller 110 for controlling the operation of the other components and doing necessary calculations in combining the measurement data; a transducer excitation signal generator 120 for producing predetermined group phase combinations of excitation signals 400 responsive to control signals 112 produced by controller 110; a transducer output signal combiner 130 responsive to control signals 113 produced by controller 110 for selectively connecting the outputs 410 of the second receiver electrode array 320A and the outputs 420 of the third receiver electrode array 320B in different combinations to produce resultant transducer output signals 430 for subsequent processing depending on the measurement mode, as discussed more fully hereinbelow; a dual − ramp A/D converter 140 responsive to control signals 114 for converting the amplitude ratios of pairs of successive resultant transducer output signals 430, which correspond to different transmission paths through the transducer, to time intervals T from which position measurements in each measurement mode can be derived by controller 110; and a display 150 responsive to output signals 115 produced by controller 110 for displaying the values of the positions calculated by controller 110.

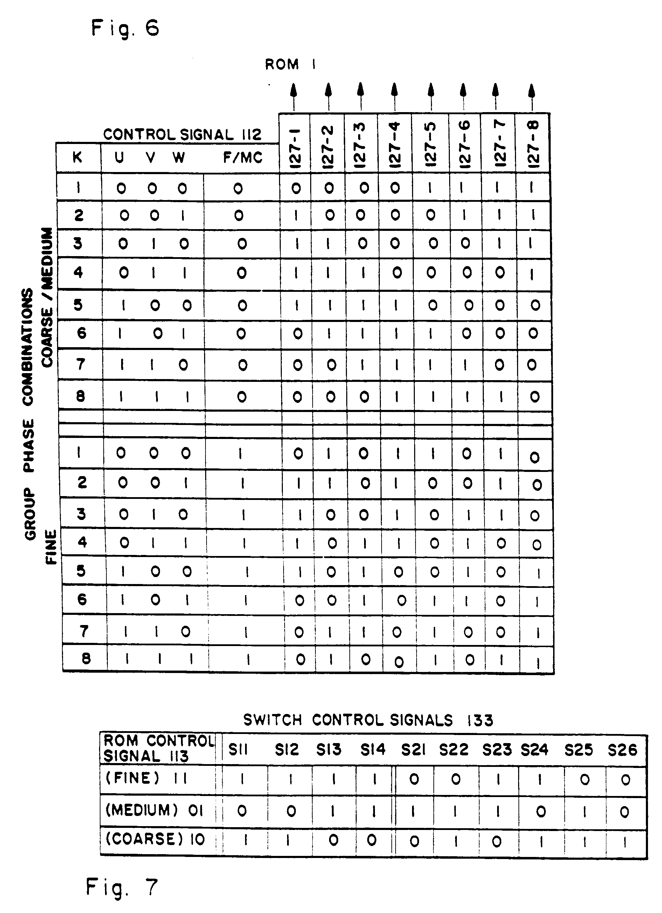

As shown in Fig. 5, transducer excitation signal generator 120 advantageously comprises a clock oscillator 122 for producing a high frequency square wave clock signal 123 having a frequency $f_o$; and a modulator 128 for producing predetermined sequences (i.e., group phase combinations) of inverted and noninverted signals 123 as transducer excitation signals 400. Preferably, the clock frequency $f_o$ is selected so that each clock cycle corresponds to the phase shift represented by one increment of the desired fine wavelength resolution. Advantageously, as shown, modulator 128 comprises an array of N exclusive − OR logic gates 128 − 1 to 128 − 8, each gate having one input connected to the clock signal 123 and the other input connected to a gate control signal 127 − 1 to 127 − 8 produced by a read − only memory 126 (ROM1) in response to controller control signals 112. As shown in the table of Fig. 6, control signals 112 advantageously are four bit binary words, the values of which, as defined by bits U, V, W and F/MC, determine which of sixteen different group phase combinations of ROMI outputs 127 − 1 to 127 − 8 are produced, with eight being used for the fine (F) measurement mode (bit F/MC = 1) and eight being used for the medium (M) and coarse (C) measurement modes (bit F/MC = O). (As will be appreciated by those skilled in the art, when a gate control signal 127 is low (O), the excitation signal produced by the associated gate 128 is the clock signal 123, and when a gate control signal is high (1), the excitation signal produced is inverted relative to signal 123.)

As shown in Fig. 5, the respective excitation signals 400 produced by excitation signal generator 120 advantageously are connected in fixed consecutive numerical sequence to corresponding ones of the transducer input terminals 316 − 1 to 316 − 8, to which are respectively connected the first transmitter electrodes in each group of N electrodes according to the relative order in which the electrodes are physically arranged in the group, as opposed to the order of the relative fine wavelength segment (phase) positions occupied by the group electrodes. That is, the first signal 400 − 1 is applied to the first transmitter electrode 312 − 1 in each group, the second signal 400 − 2 is applied to the second transmitter electrode 312 − 2 in each group, and so on, with the Nth signal 400 − N being applied to the Nth transmitter electrode 312 - N in each group. Accordingly, in the coarse and medium modes, the various group phase combina-
tions consist of sequences of four consecutive noninverted and four consecutive inverted excitation signals,
with the electrodes to which the noninverted and inverted signals are applied in each group being
successively shifted by one electrode group phase position from one group phase combination to the next.
That is, for group phase combination K = 1 shown in Fig. 6, transducer input terminals 316 - 1 to 316 - 4 are
fed with non - inverted excitation signals, while terminals 316 - 5 to 316 - 8 are fed with inverted excitation
signals. For the next successive group phase combination (K = 2), terminals 316 - 2 to 316 - 5 are fed with
non - inverted signals and terminals 316 - 6 to 316 - 1 are fed with non - inverted signals; and so on.

In contrast, in the fine measurement mode, because of the electrode geometry used in the illustrative
example, the same group phase combinations of excitation signals 400 must be applied to the first
transmitter electrodes in each group according to the relative phase position (fine wavelength segment
position) of each electrode within the group. With the fixed connection of the excitation signal generator
outputs 400 to the transducer input terminals, this necessitates the generation of the second set of group
phase combinations shown in Fig. 6 for the fine mode, which reflects the relation of each input terminal 316
to a relative fine wavelength segment position as follows:

| Terminal Number | Electrode Segment Position |
|---|---|
| 316-1 | 1 |
| 316-2 | 6 |

| (cont'd) Terminal Number | Electrode Segment Position |
|---|---|
| 316-3 | 3 |
| 316-4 | 8 |
| 316-5 | 5 |
| 316-6 | 2 |
| 316-7 | 7 |
| 316-8 | 4 |

It will be appreciated that the outputs 400 of excitation signal generator 120 could advantageously
alternatively be connected to the transducer input terminals 316 through a controllable interface circuit
which determines the sequence in which the respective excitation signals are applied to the input terminals,
in which case only one set of group phase combinations of excitation signals need be generated. It will also
be appreciated that for other transducer electrode geometries, such as, e.g., N = 8 and $W_{t1}$ $9W_{r1}$, the
sequence of relative fine wavelength segment positions occupied by the first transmitter electrodes in each
group is the ascending numerical sequence 1 - 2 - 3 - 4 - 5 - 6 - 7 - 8, and thus that the same set of group
phase combinations can be used in those cases both for coarse/medium and for fine measurements.

As shown in Fig. 5, transducer output signal combiner 130 advantageously comprises an electronic
switching network, generally denoted 132, responsive to binary switch control signals 133 produced by a
read - only memory 134 (ROM2) in response to two bit word controller signals 113 indicating the
measurement mode, and a differential amplifier circuit 136 connected to the outputs of switching network
132 and producing resultant transducer output signals 430 as an output. As shown, switching network 132
has four input terminals A, B, C and D, to which are respectively connected the transducer outputs 410 and
420. Switches S11, S12, S13, S14, S21, S22, S23, S24, S25 and S26 are responsive to control signals 133,
as shown in Fig. 7, such that a switch is in the up position shown in Fig. 5 (e.g., switch S11) when the
corresponding control signal is high ("1") in Fig. 7), and is in the down position shown in Fig. 5 (e.g., switch
S21) when the corresponding control signal is low ("0" in Fig. 7). Switches S11 - S26 are interconnected as
shown such that the resultant signals 430 constitute the following combinations of inputs in response to the
switch control signals 133 having the values shown in Fig. 7 for each of the three measurement modes:

FINE: Signal 430 = (A + B) − (C + D)
MEDIUM: Signal 430 = C − D
COARSE: Signal 430 = A − B

11

A/D converter 140 comprises, as shown in Fig. 5, a synchronous demodulator 142, which is controlled by the same clock signal 123 used to generate excitation signals 400, for producing a demodulated DC transducer signal 440 that is proportional to the amplitude of the resultant transducer output signal 430 produced by signal combiner 130; an integrator 144 responsive to control signals 114 for dual − ramp integrating pairs of transducer signals 440, as will be described in more detail hereinbelow; and a comparator 146 for detecting the polarity and zero crossings of the integrated output signals 450 produced by integrator 144 and producing feedback signals 115 for use by controller 110, as will be described in more detail hereinbelow.

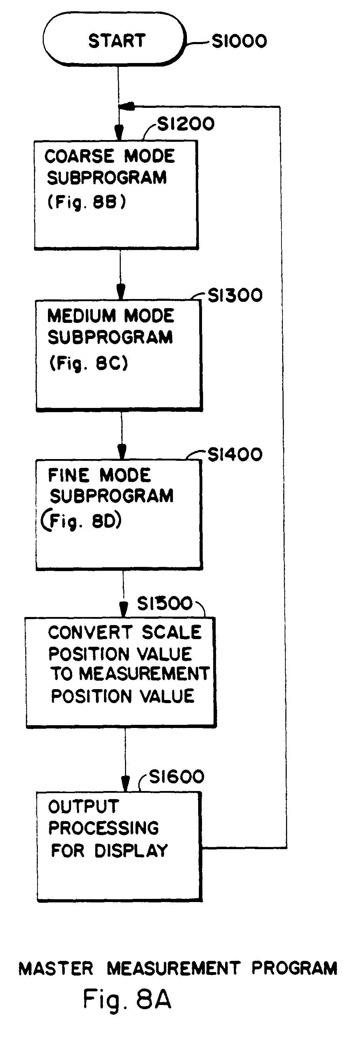

Controller 110 is programmed to control transducer excitation signal generator 120, transducer output signal combiner 130 and A/D converter 140; and to process the measured data for obtaining a position value in accordance with the flow charts shown in Figs. 8A − 8E. Referring to Fig. 8A, which illustrates the master measurement program controlling a position measurement, when the controller 110 is activated in a conventional manner to commence a measurement (Step S1000), coarse, medium and fine mode mea − surement subprograms (Steps S1200, S1300 and S1400) are successively performed to obtain coarse, medium and fine resolution scale position values $M_c$, $M_m$ and $M_f$. As will be explained in more detail hereinbelow, the medium and fine mode measurement subprograms each operate to cause correction, as appropriate, of the scale position value obtained from the previous level of measurement. Once the final values of the three scale position values $M_c$, $M_m$ and $M_f$ have been obtained after completion of the fine mode measurement subprogram, the scale position values are converted (Step S1500) into an absolute position measurement value $M_p$. A measurement cycle is completed by performing conventional processing operations (Step S1600) associated with display of the position measurement value by display 170. For example, such operations can advantageously include correction of the position measurement value for any zero offset; conversion of the position measurement value to inches; conversion of the binary value to an appropriate output format; e.g., binary coded decimal (BCD); and conversion to the desired display format.

As is explained in more detail hereinbelow, the A/D conversion of the demodulated resultant transducer output signals 440 for each measurement mode is dimensioned for the illustrative example of transducer 12 so that each incremental change in the scale position value data has the following relation to relative displacement of the transducer supporting members with respect to the measurement axis:

$$\textbf{Fine Mode: } \texttt{1 data increment} = 1024/512 = 2 \text{ microns}$$

$$\textbf{Medium Mode: } \texttt{1 data increment} = 40 \times \frac{1024}{320} = 128 \text{ microns}$$

$$\textbf{Coarse Mode: } \texttt{1 increment} = 40 \times \frac{1024}{320} = 5120 \text{ microns}$$

Accordingly, conversion of the scale position values to a corresponding position measurement value (step 1500) simply requires combining the three scale position values according to the following weighting formula:

$$M_p = 2M_f + 128M_m + 5120M_c.$$

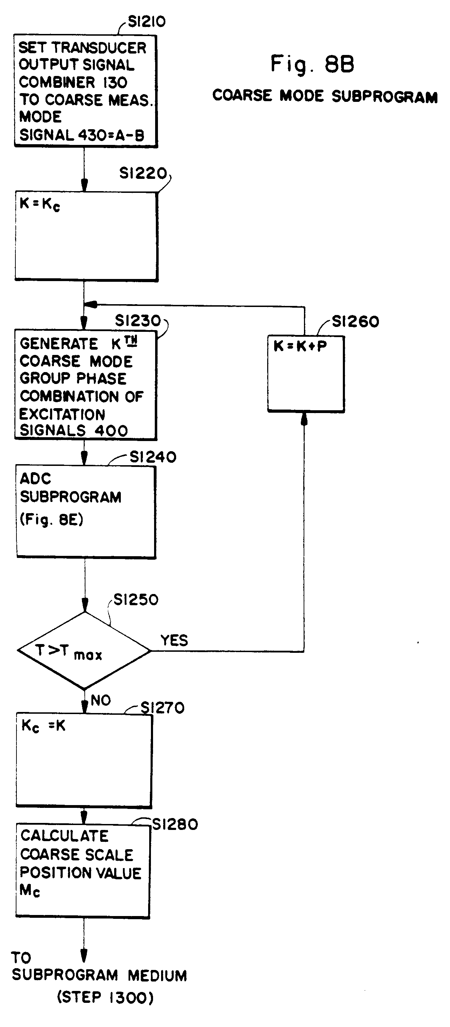

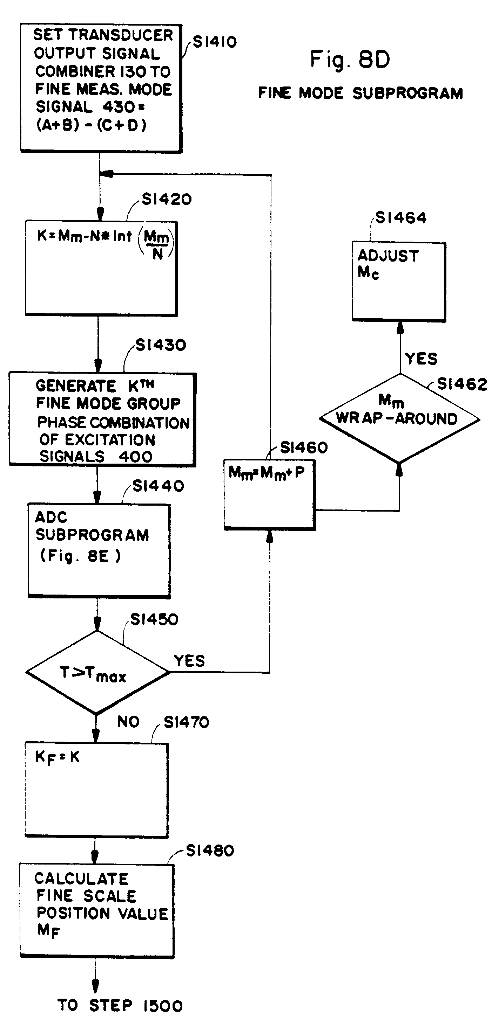

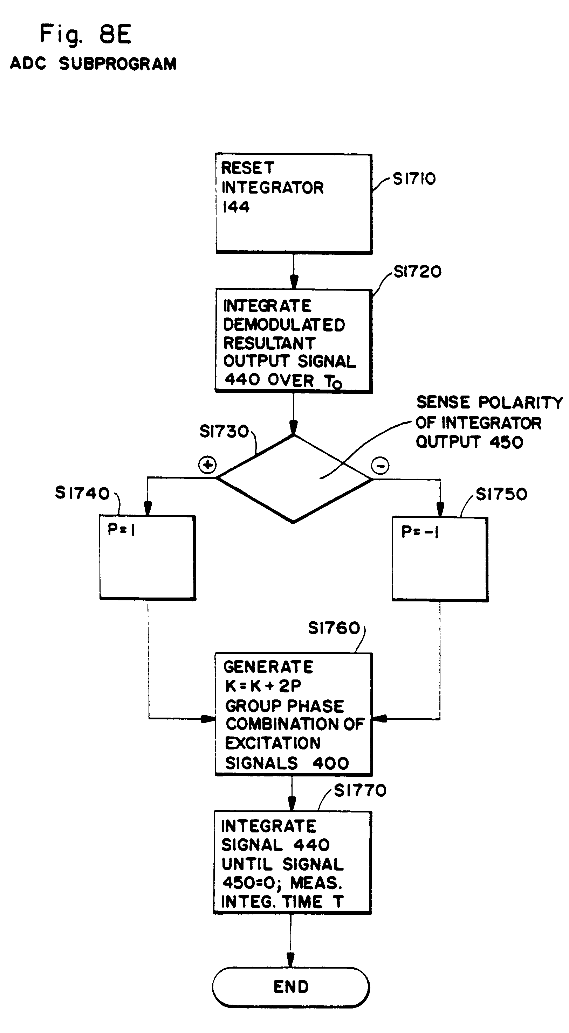

As indicated in Figs. 8B − 8D, in each of the three coarse, medium and fine measurement modes, the same A/D conversion (ADC) subprogram (steps S1240, S1340 and S1440, respectively) is performed. In each measuring mode, controller 110 initially selects a Kth one of the N possible group phase combinations of transducer excitation signals 400 to be generated, as will be described in more detail hereinbelow, and controls signal combiner 130 to produce the resultant transducer output signal 430 appropriate for the measurement mode. Referring to the flow chart of Fig. 8E, pursuant to the ADC subprogram controller 110 first causes integrator 144 to be reset to a predetermined "zero" output voltage (step S1710). (It will be appreciated by those of ordinary skill in the art that the zero level of the integrator is not necessarily an absolute zero voltage, but can be any voltage level that in the design of the circuits is selected to be the signal 0 level.) Controller 110 then causes the integrator to integrate the demodulated resultant transducer output signal 440 for a predetermined time period $T_0$ (step S1720). Controller 110 then checks (step S1730) the polarity of the integrator output 450 as sensed by comparator 140 (signal 115), and a polarity indicator constant P is set to a plus or a minus 1 value according to the sensed polarity (steps S1740 and S1750).

Controller 110 then selects a new Kth group phase combination of transducer excitation signals 400 according to the value of K + 2P (step S1760), and the demodulated resultant transducer output signal 440 produced by the new group phase combination of exciation signals is then integrated until the output of integrator 144 reaches zero as sensed by comparator 146 (step S1770). During the second integration, the integration time T is measured by an internal counter in the controller 110, which is incremented by clock signal 123 until the comparator output signal 115 indicates a zero integrator output. If the integrator output during the second integration interval does not reach zero within a predetermined time $T_{max}$, each of the measurement mode subprograms goes into a loop outside the ADC subprogram (step S1250, S1350, S1450), and changes the group phase combination of excitation signals used to generate the initial transducer output signal 440 integrated during the initial integration of the ADC subprogram (step S1720), as will be explained in more detail hereinbelow.

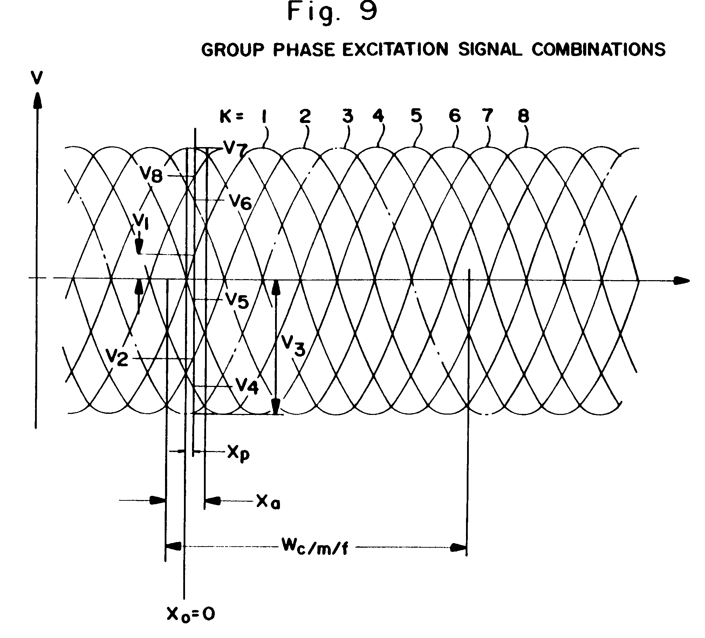

The objective of the ADC subprogram described hereinabove is to measure the ratio of i) one of the resultant transducer output signals that can be produced from the set of group phase combinations of excitation signals for a given measurement mode which produces a signal close to the zero – crossing for the above – described fine and coarse/medium transfer functions; and ii) a resultant transducer output signal for a transfer function that is one – quarter wavelength away from the initial signal. Referring to Figure 9, if the actual measurement position $x_p$ is located relative to a zero – crossing position $x_o$ as illustrated, the first integration performed by integrator 144 with the K = 1 group phase combination of excitation signals shown in Fig. 6 would produce an output voltage

$$V_1 = V \sin\left(2\pi\left(\frac{x}{W} - \frac{1}{8}\right)\right);$$

where V equals the input voltage of the excitation signals 400, and W equals the coarse, medium or fine wavelength $W_c$, $W_m$ or $W_f$. During the first integration interval, the final output voltage of the integrator would be voltage $V_1$ multiplied by time $T_0$.

Referring to Figure 9, voltage $V_1$ would be positive (P = 1) and the next integration interval would be performed with the transducer output signal resulting from the K + 2 = 3 group phase combination of excitation signals, which provides reverse integration of the integrator output. That is, the input voltage to the integrator would thus have an amplitude $V_3$ = Vsin ($2\pi$ (x/W − 3/8)). Since this signal is 90 degrees out of phase with the first signal, (negative in this example), the integrator output would decrease toward zero. When the integrator signal reaches zero at time T, $V_1 T_o - V_3 T = 0$, and therefore $T = T_0(V_1/V_3)$. With $V_1$ and $V_3$ being sinusoidal functions of $x_p$, the relative position of the transducer support members with respect to a reference position, and $V_3$ being 90 degrees from $V_1$, the above equation for T is a tangens function:

$$T = T_0 \tan(2\pi(x/W − 1/8)).$$

This tangens function is reasonably linear up to an angle of 22.5 degrees (W/16). Therefore the value of T can be used as measurement data for further linear computations for determining the measurement position $x_p$ within this range. (If increased accuracy is required, the deviation of the tangens function from a linear function can be corrected in the subsequent computer processing.)

In order to take advantage of the abovementioned linearity in the tangens function, a given group phase combination of excitation signals can be used for measurements only within a limited spatial range $X_a$, and the comparison of the second integration time T with a predetermined maximum value ensures that measurements are made within this range. If the time T exceeds the predetermined maximum, a new group phase combination of excitation signals is used for the initial integration, and the process is repeated until a second integration time T is obtained which is within the predetermined limit.

As a specific example, with the exemplary embodiment of transducer 12 described hereinabove, 320 (i.e. 40*8) scale position value data increments advantageously equal one coarse wavelength $W_c$ and one medium wavelength $W_m$ in the respective measurement modes; and 512 (64 x 8) scale position value increments equal one fine wavelength $W_f$ in the fine measurement mode. A spatial range $X_a$ = (360/16) degrees thus corresponds to 320/16 = 20 data increments in the coarse and medium modes, and to 512/16 = 32 data increments in the fine measurement mode. Counts larger than these two values in the respective measurement modes are thus outside the spatial range $X_a$. Integration times $T_0$ and $T_{max}$ are accordingly set so that:

$T_{max} = 20 = T_0 \tan(360/16)$ for the coarse and medium measurement modes; and

$T_{max} = 32 = T_0 \tan (360/16)$ for the fine measurement mode.

This relationship produces a value of 48 clock–cycles for $T_0$ in the coarse and medium measurement modes, and a value of 77 clock–cycles for the fine measurement mode.

Referring to Fig. 8B, the coarse measurement mode sub–program starts (step S1210) by generating the control signal 113 which sets transducer output signal combiner 130 to produce the resultant transducer output 430 appropriate for the coarse measurement mode as described hereinabove. Controller 110 next selects a group phase combination number K from among the coarse/medium combinations shown in Fig. 6 (step S1220). Preferably, following initial start up, the value of K is set equal to the value of $K_c$ calculated during the previous coarse measurement. In most cases, when the rate of change of the measurement position value is not great, this selection criteria will result in an initial K–number very close to the correct value for the position being measured. In those cases where no previous K–value exists, such as, for example, at start up of the caliper following a power–off mode, an arbitrary value of K can be used as the initial value. The program will keep iterating through the coarse measurement mode until the correct value of K has been reached.

Once the K–value has been selected, the corresponding group phase combination of transducer excitation signals are generated (step S1230) and the ADC subprogram described hereinabove is performed (step S1240). The value of second integration time T produced by the ADC subprogram is compared with the value of Tmax for the coarse measurement mode (20 for the exemplary embodiment described herein) (step S1250). For values of T larger than 20, the K–number is adjusted one step up or down dependent on the P value generated by the ADC subprogram (step S1260). Thereafter the measurement loop (steps S1230–S1260) is repeated again with the corresponding new K–number used to select the initial group phase combination of excitation signals used to generate the initial resultant transducer output signal 430. This process continues until a value of time T not greater than 20 is obtained from the ADC subprogram.

Next, a value $K_c$ is updated with the value of K for which the measurement time T was within the predetermined limit. The $K_c$ value will be used as the initial K value for the next coarse measurement, and is also used to obtain a value $M_c$ for the present coarse scale position. For the exemplary embodiment described herein:

$$M_c = 40 K_c + PT.$$

In the case of the exemplary embodiment, $M_c$ can properly have values ranging from 0 to 319. When the computed value of $M_c$ is outside this range, controller 110 performs a "wrap–around" calculation, i.e., a calculated value of 321 equals a measurement value of 1, and a calculated value of −3 equals a measurement value of 317. By choosing the resolution of a coarse wavelength measurement to be 320, each increment of a $M_c$ value corresponds to $1/(40 \times 8) = 1$ phase–step (equals one K–increment in the medium measurement mode.

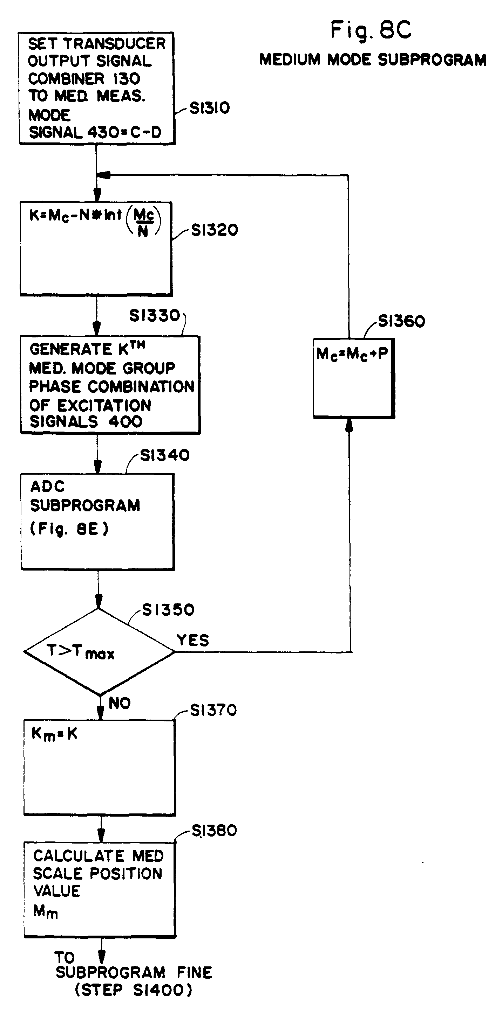

Referring to Figure 8C, the medium measurement mode subprogram is substantially similar to the coarse mode subprogram. Controller 110 starts (step S1310) by generating a control signal 113 which sets the signal combiner 130 to produce the resultant transducer output signal 430 which is appropriate for medium measurements. Next (step S1320), the controller calculates the K–number of the group phase combination of excitation signals from the among the coarse/medium combinations shown in Figure 6. Unlike the coarse mode subprogram, the medium mode subprogram uses the coarse scale position value $M_c$ obtained from the coarse mode computation according to the following formula $K = M_c - N(\text{Int} - (M_c/N))$, where $\text{Int}(M_c/N)$ is the integer value of the ratio $M_c/N$.

Controller 110 then causes the K group phase combination of excitation signals to be generated and the ADC subprogram to be performed (steps S1330 and S1340). Similarly to the coarse mode subprogram, if the value of the second integration time T exceeds 20, the value of $M_c$ used to calculate K is adjusted one step up or down dependent on the P value produced by the ADC subprogram (step S1360). Thereafter the measuring loop (steps S1320–S1360) is repeated again with the corresponding new K–number. This process continues until a value of second integration time T within the predetermined limit is obtained from the ADC subprogram. The value of $K_m$ is updated (step S1370) and the medium scale position value $M_m$ is calculated (steps S1380) using (for the exemplary embodiment) the formula:

$$M_m = 40 Km + PT.$$

The medium measurement mode also utilizes a wrap–around computation similar to that employed in the coarse measurement mode to derive the value of $M_m$. Choosing 320 as the resolution for one medium wavelength makes one increment in the medium scale position value equal to $1/(40 \times 8) = 1$ phase step (=

1 K – increment) in the fine measurement mode.

Referring to Fig. 8d, the fine measurement mode subprogram is generally similar to the medium mode subprogram. Controller 110 starts (step S1410) by setting the signal combiner 130 to produce the resultant transducer output signal 430 which is appropriate for fine measurements. Controller 110 next calculates (step S1420) a K number for the initial group phase combination of excitations signals using the previously calculated medium scale position value Mm according to the following formula:

$$K = M_m - N(Int(M_m/N))$$

After causing the Kth group phase combination of excitations signals to be generated (step S1430), the ADC subprogram is performed as before (step S1440). Similarly to the course/ medium measurement modes, if the calculated value of T exceeds limit $T_{max}$, the $M_m$ number used to calculate K is incremented by one step up or down dependent on the P value produced by the ADC subprogram (steps S1450 and S1460). If this adjustment causes the $M_m$ value to pass the 319/O value in an up or down direction (step S1462), the $M_c$ value is also incremented up or down by one increment accordingly. Thereafter, the measurement routine (steps S1420 – S1464) is repeated again with the new K number, and the process continues until a value of time T within the limit $T_{max}$ is obtained from the ADC subprogram. Next the value of $K_f$ is updated with the last calculated value of K (step S1470) and the fine scale position value $M_f$ is then calculated (step S1480) using (for the exemplary embodiment) the formula:

$$M_f = 64K_f + PT.$$

With the dimensions provided in the illustrative example, the value $M_f$ can have values within the range 0 – 511. Similarly to the other two measuring modes, controller 110 performs a wrap – around computation if the calculated value of $M_f$ exceeds this range. For example, a calculated value of 513 equals a measurement of 1, and a calculated value of – 3 equals a measurement value of 509. The choice of the resolution value of 512 for one fine wavelength $W_f$ makes one increment in a fine scale position measurement equal to 1/(64x8) = 1/512 of a fine wavelength, which equals two microns with the exemplary dimension of $W_f$ equal 1.024 $M_m$.

Conversion step S1500 of the master measurement program is carried out as described hereinabove using the values of $M_c$, $M_m$ and $M_f$ obtained from performing all three measurement mode subprograms. Thus, the initial value of $M_c$ obtained from performing the coarse mode subprogram may be subsequently modified in performing the medium and fine mode subprograms and the initial value of $M_m$ may be modified in performing the fine mode program, as described hereinabove. It will be appreciated that provision is made in the medium and fine measurement mode subprograms for successively correcting the higher wavelength measurement data based on the results from the lower wavelength data because there is some ambiguity in the least significant bits of the higher wavelength measurements, which bits in the next lower wavelength correspond to the K – number. In the lower wavelength measurement mode, the validity of the K – number is tested in the ADC subprogram with a higher level of accuracy. Accordingly, by reflecting in the higher wavelength measurement values any adjustment of the K – number in the lower wavelength conversions, the ambiguities in the higher wavelength measurements are resolved, and a correct position measurement value is obtained.

It will be appreciated that the foregoing preferred embodiments are merely illustrative of the present invention, and that numerous modifications can be made therein consistently with the spirit and scope of the present invention. In particular, it will be appreciated that the preferred embodiments described herein are adapted for making combined coarse, medium and fine resolution measurements to obtain an accurate absolute position measurement. A central feature of coarse resolution measurements in accordance with the present invention is the provision of the corresponding first receiver electrode – second transmitter electrode arrangement wherein the second transmitter electrodes are connected in an offset relationship to the corresponding first receiver electrodes which is a predetermined function of the position of the second transmitter electrodes with respect to a reference position; and the provision of a further receiver electrode array configured to sense the offset function D(x). This aspect of the present invention is not dependent on the particular distribution of the first transmitter and first receiver electrodes, nor the manner of signal processing employed to sense the capacitance functions.

Although preferable, it is not necessary for coarse measurements that the first transmitter electrodes have a uniform distribution such that the transmitting wavelength $W_{t1}$ of the groups of N first transmitter electrodes is the same for all of the groups, so long as there is a correspondence between the distribution of the first transmitter electrodes and the configuration of the second receiver electrodes, adjusted for the rate of offset between the first receiver electrodes and the second transmitter electrodes. Further, N, the number of first transmitter electrodes in a group, can have a value as small as 2.

In addition, the distribution of the first receiver electrodes is not of primary importance to coarse measurements in accordance with the present invention. The spacing between first receiver electrodes can even be completely random. It is also possible to obtain coarse measurements with less than one first receiver electrode per transmitter wavelength $W_{t1}$ by superimposing groups of first transmitter electrodes and sensing the transfer functions for the resulting plurality of transfer channels from the first transmitter electrodes via the first receiver electrodes and the second transmitter electrodes to the second receiver electrodes. If the number of such channels is at least three, and the width of the first receiver electrodes is not an integral of the first transmitter wavelength $W_{t1}$, it is possible to measure the function D(x), and thereby obtain a coarse position measurement. (A transmission channel is defined from an excitation signal connection to any one of the N first transmitter electrodes in a first transmitter electrode group via the first receiver electrode and the second transmitter electrodes to one of the second receiver electrode connec-tions. As described hereinabove, the one second receiver electrode connection can also be 2 connections of opposite polarity. More defined transmission channels can also be obtained by adding together several such connections, as is done in the preferred embodiments described hereinabove.)

Each transmission channel has a transfer function that varies with the displacement between the first and second support members (i.e., is a function of x . The amplitude of the transfer functions is preferably, but not necessarily, equal for all of the transmission channels; and is phased-shifted (in the x direction) between channels. The shape of these transfer functions can be, for example, sinusoidal, triangular or some other predetermined shape. A sinusoidally shaped transfer function is preferred because of the lesser dependence of the transfer function shape on the gap between the first and second support members. Two transmission channels that are phased-shifted one quarter wavelength in the x direction provides, in principle, enough information for determining the position anywhere within the period length of the function. It is thus possible to make a functioning device according to the present invention with N equal to two.

By making the first transmitter electrode and second receiver electrode arrays have a regular, periodic structure, it becomes simpler to design and to predict the performance of the measuring system. Still further, it is possible to sense the offset function D(x) without directly sensing the voltage distribution of the electric field pattern produced by the second transmitter electrodes in response to excitation of at least one group of first transmitter electrodes. An example of another way of sensing the offset function is to rely on at least two transfer functions for signals between the first transmitter array and the second receiver array via the first receiver electrodes and the second transmitter electrodes. If the shape and relation between the transfer functions with respect to the measurement direction is known, the measurement position can be derived from measurements of the transfer functions.

The ability of a measuring transducer in accordance with the present invention to provide both fine and coarse-medium resolution measurements using the same set of electrodes results from the lack of restrictions on the configuration of the first receiver electrode array for coarse resolution measurements. The first receiver electrode array can thus be given a periodicity and electrode shape that meets the requirements for fine resolution measurements. A first receiver electrode array is thus given a pitch $P_{r1}$ and electrode shape which, in combination with the electrode pitch and shape of the first transmitter electrodes, provides a periodic transfer function with a wavelength $W_f$ for signals transmitted from the first transmitter electrodes to the first receiver electrodes. A pitch $P_{r1}$ equal to the fine wavelength $W_f$ and an electrode which is smaller than $W_f$ (and preferably not larger than $W_f/2$) provides the desired periodicity of the transfer function to one first transmitter electrode of a width which is preferably not greater than $W_f/2$. Several first transmitter electrodes positioned at intervals which are integral multiples of wavelength $W_f$ can be connected together to provide a stronger transducer output signal. It is also possible to obtain the same transfer function with first receiver electrodes positioned at intervals which are integral multiples of wavelength $W_f$ combined with first transmitter electrodes which are positioned at a regular pitch equal to wavelength $W_f$. There may even be some combination of irregular distributions of first transmitter and first receiver electrodes that results in the desired transfer function. However, in such embodiments all of the first transmitter and first receiver electrodes should be positioned at locations which are integral multiples of wavelength $W_f$ with respect to a common reference point.

## Claims

1. Method for making absolute measurement of positions in a Capacitive-type measuring apparatus comprising:

    first and second support members (20, 30), said support members being relatively displaceable

16

with respect to each other, and at least one of said support members being displaceable relative to a measurement axis (X);

electrode array means (210A, 210B, 220A, 220B, 310, 320A, 320B) disposed on said first and second support members (20, 30) in relative alignment with said measurement axis (X) for providing a plurality of discrete signal transmission paths each having a capacitive transfer function which varies in dependence on the relative positions of said first and second support members (20, 30) with respect to each other; said capacitive transfer function having a first component which varies over a first predetermined wavelength according to the position of the associated transmission path relative to a reference position on one of the support members, and a second component which varies according to a predetermined function of the displacement between said first and second support members over a second predetermined wavelength shorter than said first predetermined wavelength;

said electrode array means comprising:

a transmitter electrode array (310) having at least one group of N adjacent transmitter electrodes (312) spaced from each other relative to the measurement axis (X), wherein N has a value which is an integer multiple of four;

an array of first receiver electrodes (210A, 210B) disposed on said second support member (30) in alignment with said measurement axis (X) and such that differing portions of said first receiver electrode array (210A, 210B) are capacitively coupled with said transmitter electrode array (310) in dependence on the relative positions of said supporting members (20, 30);

said first receiver electrodes (212A, 212B) being spaced from each other relative to the measurement axis by a pitch $P_{r1}$ defining a scale wavelength $W_f$,

said at least one transmitter electrode (312) group defining a transmitting wavelength $W_t$, and

the transmitter electrodes (312) in each group being positioned within the group so as to respectively occupy predetermined group positions which span a distance greater than one wavelength $W_f$, and such that each group position corresponds to the relative position of a different one of a group of relative fine wavelength ($W_f$) segment positions obtained by dividing the transmitting wavelength $W_t$ into intervals corresponding to the fine wavelength, and dividing each interval into N equal segments; and

detector electrode means for producing first and second outputs in response to excitation signals applied to said at transmitter electrode array, said detector electrode outputs individually varying in accordance with said first transfer function component and producing when combined a signal which varies in accordance with said second transfer function component;

excitation signal generating means (120) for selectively generating groups of N excitation signals (400) for application to the respective N electrodes of said at least one group of transmitter electrodes (312) in a selected one of first and second spatial orders;

said first spatial order being defined by a first order of connection according to the sequence of positions of the transmitter electrodes (312) relative to each other in said at least one transmitter electrode group, and said second spatial order being defined by a second order of connection according to the sequence of relative fine wavelength segment positions in which the respective transmitter electrode group positions are arranged;

each of said groups of excitation signals (400) comprising two sets of excitation signals which are phase inverted with respect to each other and in spatial phase quadrature when applied to said transmitter electrodes (312), and wherein the relative spatial phase positions occupied by the respective sets of excitation signals (400) in each group of excitation signals successively incrementally change from one group to the next;

control means (110) for controlling said excitation signal generating means (120) to selectively apply a pair of first and second ones of said groups of excitation signals to said at least one group of transmitter electrodes (312);

output signal selecting means (130) for selecting a signal corresponding to said first and second detector electrode outputs (410, 420) or to said combined detector electrode output signal as an electrode array means output signal (430), and thereby producing successive first and second electrode array means output signals in response to said pair of excitation signal groups;

means (142) for demodulating said first and second output signals (410, 420) to produce first and second demodulation signals (440), and means (144) for performing a dual ramp integration of said first and second demodulation signals (440) wherein said first demodulation signal is integrated for a predetermined time interval ($T_o$) by said integration means (144), and said second demodulation signal is integrated by said integration means (144) until the integration means output returns to a reference level, said first and second ones of said groups of excitation signals being selected such that said

EP 0 404 980 B1

integration of said second demodulation signal causes integration of the integration means output in the reverse direction from said integration of said first democulation signal output;

measuring means (146) for measuring the integration time (T) of said second demodulated signal integration and for producing an output when the integration time exceeds a predetermined limit value ($T_{max}$);

said control means (110) being responsive to said output of said integration time measuring means (110) for resetting said demodulation (142) and dual ramp integration (144) means, for repetitively selectively applying a different further pair of first and second ones of said groups of excitation signals (400) to said at least one group (310) of transmitter electrodes, and for causing said demodulation and dual ramp integration means to integrate the resultant first and second demodulation signals (440) until there is no output from said integration time measuring means (110);

said control means (110) producing a scale position value when said integration time measuring means (146) does not produce an output;

said control means (110) including a master control loop for controlling said excitation signal generating means (120) and said output signal selecting means (130) so as to perform a measurement cycle for successively producing:

a first scale position value $M_c$ from a second demodulation signal (440) produced from a second electrode array means output signal corresponding to said first and second detector electrode outputs (410, 420) produced in response to a group of excitation signals (400) generated in said first spatial order;

a second scale position value $M_m$ from a second demodulation signal (440) produced from a second electrode array means output signal corresponding to said combined detector electrode output signal produced in response to a group of excitation signals (400) generated in said first spatial order; and

a third scale position value $M_f$ from a second demodulation signal (440) produced from a second electrode array means output signal corresponding to said first and second detector electrode outputs produced in response to a group of excitation signals (400) generated in said second spatial order; and

combining said first, second and third scale position values to produce an absolute position measurement ($M_p$); said method being

characterized in that

each group of N excitation signals (400) is assigned a value K, where K ranges between 1 and N, and at the beginning of each portion of the measurement cycle for generating successive pairs of excitation signal groups to produce a scale position value, the first one of said excitation signal groups in the initial pair of excitation signal groups is selected according to a predetermined initial value of K, and thereafter the value of K is incremented or decremented in accordance with the polarity of the first demodulation signal integration result to produce a new value of K for selecting the next first one of said excitation signal groups (400) in the next further pair of excitation signal groups;

said $M_c$ scale position value is computed according to the formula $M_c = A^*K_c + P_c{}^*T_c$, unless the value so computed is outside a predetermined range, in which case a further wrap−around calculation is performed to convert the computed value to a value within the range, where A is a predetermined constant selected according to the relationship between the wavelengths $W_c$ and $W_m$, $K_c$ is the value of K which resulted in said measuring means (110) not producing an output during the portion of the measurement cycle for producing said $M_c$ value, $P_c$ is the polarity of the first demodulation signal integration result for the next further pair of excitation signal groups causing said measuring means not to produce an output, and $T_c$ is the time required for integration of the second demodulation signal (440) for the pair of excitation groups causing said measuring means not to produce an output;

sad $M_m$ scale position value is computed according to the formula $M_m = B^*K_m + P_m{}^*T_m$, unless the value so computed is outside a predetermined range, in which case a further wrap−around calculation is performed to convert the computed value to a value within the range, where B is a predetermined constant selected according to the relationship between the wavelengths $W_m$ and $W_f$, $K_m$ is the value of K which resulted in said measuring means not producing an output during the portion of the measurement cycle for producing said $M_m$ value, $P_m$ is the polarity of the first demodulation signal integration result for the pair of excitation signal groups causing said measuring means not to produce an output, and $T_m$ is the time required for integration of the second demodulation signal (440) for the pair of excitation groups causing said measuring means not to produce an output;

said $M_f$ scale position value is computed according to the formula $M_f = C^*K_f + P_f{}^*T_f$, unless the value so computed is outside a predetermined range, in which case a further wrap−around calculation is performed to convert the computed value to a value within the range, where C is a predetermined

18

constant selected according to the desired measurement resolution, $K_f$ is the value of K which resulted in said measuring means not producing an output, $P_f$ is the polarity of the first demodulation signal integration result for the pair of excitation signal groups causing said measuring means not to produce an output, and $T_f$ is the time required for integration of the second demodulation signal (440) for the pair of excitation groups causing said measuring means not to produce an output.

2. The method of claim 1 wherein the initial value of K for the portion of the measuring cycle for producing $M_m$ is selected according to the formula $K = M_c - N*Int(M_c/N)$; and the initial value of K for the portion of the measuring cycle for producing $M_f$ is selected according to the formula $K = M_m - N*Int(M_m/N)$.

3. The method of claim 2 wherein the value of $M_c$ is incremented or decremented during the portion of the measuring cycle for producing $M_m$ according to the value of the associated first demodulation signal integration result each time said measuring means produces an output.

4. The method of claim 3 wherein the value of $M_m$ is incremented or decremented during the portion of the measuring cycle for producing $M_f$ according to the value of the associated first demodulation signal integration result each time said measuring means produces an output; and if the value of $M_m$ so incremented or decremented is outside the predetermined range for $M_m$, the value of $M_c$ is adjusted correspondingly to a new value.

5. The method of claim 4 wherein the $M_f$ value, and the $M_m$ and $M_c$ values obtained as a result of producing the $M_f$ value, are weighted with respect to each other in accordance with the relative measurement dimensional value represented by each increment of the scale position values, and the weighted scale position values are summed to derive said absolute position measurement ($M_p$).

**Patentansprüche**

1. Verfahren zum Messen von absoluten Positionen in einem kapazitiven Meßwertumformer, welcher umfaßt:

ein erstes und zweites Trägerteil (20, 30), wobei die genannten Trägerteile relativ zueinander verschiebbar sind, und wenigstens eines der Trägerteile relativ zu einer Meßachse (X) verschiebbar ist;

eine Anordnung von Elektroden (210A, 210B, 220A, 220B, 310, 320A, 320B), welche auf den genannten ersten und zweiten Trägerteilen (20, 30) relativ zu der genannten Meßachse (X) ausgerichtet sind, zur Bereitstellung einer Vielzahl von diskreten Signalübertragungpfaden, von denen jeder eine kapazitive Übertragungsfunktion besitzt, welche in Abhängigkeit der relativen Positionen der ersten und zweiten Trägerteile (20, 30) zueinander variiert; wobei die genannte kapazitive Übertragungsfunktion eine erste Komponente besitzt, welche über eine erste vorbestimmte Wellenlänge gemäß der Position des zugehörigen Übertragungspfades relativ zu einer Referenzposition auf einem der Trägerteile variiert, und eine zweite Komponente, welche gemäß einer vorbestimmten Funktion der Verschiebung zwischen dem ersten und zweiten Trägerteil über eine zweite vorbestimmte Wellenlänge, welche kleiner als die erste vorbestimmte Wellenlänge ist, variiert; wobei die Anordnung von Elektroden umfaßt:

eine Anordnung von Sendeelektroden (310), welche wenigstens eine Gruppe von N nebeneinander liegenden Sendeelektroden (312) besitzt, die voneinander bezüglich der Meßachse (X) beabstandet sind, wobei N einen Wert besitzt, der ein ganzzahliges Vielfaches von Vier ist;

eine Anordnung von ersten Empfangselektroden (210A, 210B), die auf dem zweiten Trägerteil (30) entlang der genannten Meßachse (X) angeordnet sind, und weiter so angeordnet sind, daß unterschiedliche Teile der Anordnung von ersten Empfangselektroden (210A, 210B) kapazitiv mit der Anordnung der genannten Sendeelektroden (310) in Abhängigkeit der relativen Positionen der genannten Trägerteile (20, 30) gekoppelt sind;

wobei die ersten Empfangselektroden (212A, 212B) voneinander relativ zu der Meßachse mit einem Abstand $P_{r1}$ beabstandet sind, welcher eine Skalenwellenlänge $W_f$ definiert,

wenigstens eine der genannten Gruppe von Sendeelektroden (312) eine Sendewellenlänge $W_t$ definiert, und

die Sendeelektroden (312) in jeder Gruppe innerhalb der Gruppe so positioniert sind, daß sie entsprechend vorbestimmte Gruppenpositionen einnehmen, welche einen Abstand, der größer als eine Wellenlänge $W_f$ ist, überspannen, und derart, daß jede Gruppenposition mit der relativen Position einer anderen einer Gruppe von relativen Feinwellenlängen − ($W_f$)Segmentpositionen korrespondiert, welche durch Teilen der Sendewellenlänge $W_t$ in Intervalle, welche der Feinwellenlänge entsprechen, und Teilen jedes Intervalls in N gleiche Segmente erhalten wird; und

eine Detektorelektrode zum Erzeugen eines ersten und zweiten Ausgangssignals im Ansprechen auf Anregungssignale, welche an die genannte Anordnung von Sendeelektroden angelegt werden, wobei die Ausgangssignale der Detektorelektrode individuell in Übereinstimmung mit der ersten Übertra gungsfunktionskomponente variieren und wenn sie kombiniert werden ein Signal erzeugen, welches in Übereinstimmung mit der zweiten Übertragungsfunktionskomponente variiert;

eine Einrichtung zum Erzeugen von Anregungssignalen (120) zum selektiven Erzeugen von Gruppen von N Anregungssignalen (400), welche an die entsprechenden N Elektroden der genannten wenig stens einen Gruppe von Sendeelektroden (312) in einer ausgewählten von ersten und zweiten räumlichen Reihenfolge angelegt werden;

wobei die genannte erste räumliche Reihenfolge durch eine erste Verbindungsreihenfolge gemäß der Sequenz von Positionen der Sendeelektroden (312) relativ zueinander in der genannten wenigstens einen Sendeelektrodengruppe definiert ist, und die genannte zweite räumliche Reihenfolge durch eine zweite Verbindungsreihenfolge gemäß der Sequenz der relativen Feinwellenlängensegmentpositionen definiert ist, in welcher die entsprechenden Sendeelektrodengruppenpositionen angeordnet sind;

jede der genannten Gruppen von Anregungssignalen (400) zwei Sätze von Anregungssignalen umfaßt, welche phaseninvertiert zueinander und in räumlicher Phasenquadratur sind, wenn sie an die genann ten Sendeelektroden (312) angelegt werden, und wobei die relativen räumlichen Phasenpositionen, welche von den entsprechenden Sätzen von Anregungssignalen (400) eingenommen werden, in jeder Gruppe von Anregungssignalen sich von einer Gruppe zur nächsten sukzessive zunehmend verändern;

eine Steuereinrichtung (110) zum Steuern der genannten Einrichtung zum Erzeugen der Anregungssi gnale (120), um selektiv ein Paar von ersten und zweiten der genannten Gruppen von Anregungssi gnalen an wenigstens eine genannte Gruppe von Sendeelektroden (312) anzulegen;

eine Ausgangssignalauswahleinrichtung (130) zum Auswählen eines Signals, welches mit den ersten und zweiten Ausgangssignalen (410, 420) der Detektorelektrode oder mit dem kombinierten Aus gangssignal der Detektorelektrode als ein Ausgangssignal (430) der Elektrodenanordnung korrespon diert, und wobei nacheinander erste und zweite Ausgangssignale der Elektrodenanordnung im Anspre chen auf das genannte Paar von Anregungssignalgruppen erzeugt werden;

eine Einrichtung (142) zum Demodulieren der ersten und zweiten Ausgangssignale (410, 420), um erste und zweite Demodulationssignale (440) zu erzeugen, und eine Einrichtung (144) zum Ausführen einer Doppelrampenintegration der ersten und zweiten Demodulationssignale (440), wobei das genannte erste Demodulationssignal über ein vorbestimmtes Zeitintervall ($T_o$) durch die Integrationseinrichtung (144) integriert wird, und das genannte zweite Demodulationssignal von der Integrationseinrichtung (144) solange integriert wird, bis das Ausgangssignal der Integrationseinrichtung auf einen Referenz pegel zurückkehrt, die genannten ersten und zweiten Gruppen von Anregungssignalen so ausgewählt werden, daß die genannte Integration des zweiten Integrationssignals eine Integration des Ausgangssi gnals der Integrationseinrichtung in der umgekehrten Richtung zu der Integration des ersten Demodu lationsausgangssignals bewirkt;

eine Meßeinrichtung (146) zum Messen der Integrationszeit (T) der Integration des zweiten demodu lierten Signals und zum Erzeugen eines Ausgangssignals, wenn die Integrationszeit einen vorbe stimmten Grenzwert ($T_{max}$) überschreitet;

wobei die Steuereinrichtung (110) auf das Ausgangssignal der Integrationszeitmeßeinrichtung (110) anspricht, um die Demodulationseinrichtung (142) und die Doppelrampenintegrationseinrichtung (144) zurückzusetzen, zum wiederholten selektiven Anlegen eines verschiedenen, weiteren Paares von ersten und zweiten Gruppen von Anregungssignalen (400) an wenigstens eine Gruppe von Sendeelektroden (310) und zum Bewirken, daß die Demodulations − und Doppelrampenintegrationseinrichtung die resultierenden ersten und zweiten Demodulationssignale (440) solange integriert, bis kein Ausgangssi gnal von der genanten Integrationszeitmeßeinrichtung (110) erhalten wird;

wobei die Steuereinrichtung (110) einen Skalenpositionswert erzeugt, wenn die Integrationszeitmeßein richtung (146) kein Ausgangssignal erzeugt;

wobei die genannte Steuereinrichtung (110) eine Hauptsteuerschleife aufweist, zum Steuern der genannten Anregungssignalerzeugungseinrichtung (120) und der genannten Ausgangssignalauswahl einrichtung (130), um so einen Meßzyklus auszuführen, welcher sukzessive erzeugt:

einen ersten Skalenpositionswert $M_c$ aus dem zweiten Demodulationssignal (440), welches von einem Ausgangssignal der zweiten Elektrodenanordnung erzeugt wird, und den Ausgangssignalen (410, 420) der ersten und zweiten Detektorelektroden entspricht, welche im Ansprechen auf eine Gruppe von in einer ersten räumlichen Reihenfolge erzeugten Anregungssignalen (400) erzeugt werden;

20

einen zweiten Skalenpositionswert $M_m$ aus einem zweiten Demodulationssignal (440), das von dem Ausgangssignal einer zweiten Elektrodenanordnung erzeugt wird und mit dem Ausgangssignal der kombinierten Detektorelektrode korrespondiert, welches im Ansprechen auf eine Gruppe von in einer ersten räumlichen Reihenfolge erzeugten Anregungssignalen (400) erzeugt wird; und

einen dritten Skalenpositionswert $M_f$ aus einem zweiten Demodulationssignal (440), welches aus dem Ausgangssignal einer zweiten Elektrodenanordnung erzeugt wird, welches mit den Ausgangssignalen der ersten und zweiten Detektorelektroden korrespondiert, welche im Ansprechen auf eine Gruppe von in einer zweiten räumlichen Anordnung erzeugten Anregungssignalen (400) erzeugt werden; und Kombinieren der ersten, zweiten und dritten Skalenpositionswerte, um eine absolute Positionsmessung ($M_p$) zu erzeugen;

wobei das genannte Verfahren **dadurch gekennzeichnet** ist, daß

jeder Gruppe von N Anregungssignalen (400) ein Wert von K zugeordnet ist, wobei K im Bereich zwischen 1 und N liegt, und bei Beginn jedes Abschnitts des Meßzyklus zum Erzeugen von sukzessiven Paaren von Anregungssignalgruppen, um einen ersten Skalenpositionswert zu erzeugen, die erste der Anregungssignalgruppen in dem Anfangspaar von Anregungssignalgruppen gemäß einem vorbestimmten Anfangswert von K ausgewählt wird, und danach der Wert von K in Übereinstimmung mit der Polarität des Integrationsergebnisses des ersten Demodulationssignals inkrementiert oder dekrementiert wird, um einen neuen Wert für K zu erzeugen, um die nächste erste der Anregungssignalgruppen (400) in dem nächst weiteren Paar von Anregungssignalgruppen auszuwählen;

wobei der genannte $M_c$ Skalenpositionswert gemäß der Formel $M_c = A{*}K_c + P_c{*}T_c$, es sei denn, der so berechnete Wert ist außerhalb eines vorgegebenen Bereichs, in welchem Fall eine weitere Umlaufberechnung ausgeführt wird, um den berechneten Wert in einen Wert innerhalb des Bereichs umzuwandeln, wobei A eine vorbestimmte Konstante ist, welche in Übereinstimmung mit der Beziehung zwischen den Wellenlängen $W_c$ und $W_m$ ausgewählt ist, $K_c$ der Wert von K ist, welcher in der genannten Meßeinrichtung (110) resultiert, wenn diese kein Ausgangssignal während eines Teils des Meßzyklus zur Erzeugung des genannten $M_c$ Wertes produziert, $P_c$ die Polarität des Integrationsresultates des ersten Demodulationssignals für das nächst weitere Paar von Anregungssignalgruppen ist, welche die genannte Meßeinrichtung veranlaßt, kein Ausgangssignal zu erzeugen, und $T_c$ die Zeit ist, welche erforderlich für die Integration des zweiten Demodulationssignals (440) für das Paar von Anregungsgruppen ist, welches veranlaßt, daß die Meßeinrichtung kein Ausgangssignal erzeugt;

der genannte $M_m$ Skalenpositionswert gemäß der Formel $M_m = B{*}K_m + P_m{*}T_m$, berechnet wird, es sei denn, der so berechnete Wert ist außerhalb eines vorgegebenen Bereichs, in welchem Fall eine weitere Umlaufberechnung ausgeführt wird, um den berechneten Wert in einen Wert innerhalb des Bereichs umzuwandeln, wobei B eine vorbestimmte Konstante ist, welche in Übereinstimmung mit der Beziehung zwischen den Wellenlängen $W_m$ und $W_f$ ausgewählt ist, $K_m$ der Wert von K ist, welcher in der genannten Meßeinrichtung (110) resultiert, wenn diese kein Ausgangssignal während eines Teils des Meßzyklus zur Erzeugung des genannten $M_m$ Wertes produziert, $P_m$ die Polarität des Integrationsresultates des ersten Demodulationssignals für das Paar von Anregungssignalgruppen ist, welche die genannte Meßeinrichtung veranlaßt, kein Ausgangssignal zu erzeugen, und $T_m$ die Zeit ist, welche erforderlich für die Integration des zweiten Demodulationssignals (440) für das Paar von Anregungsgruppen ist, welches veranlaßt, daß die Meßeinrichtung kein Ausgangssignal erzeugt;

der genannte $M_f$ Skalenpositionswert gemäß der Formel $M_f = C{*}K_f + P_f{*}T_f$, berechnet wird, es sei denn, der so berechnete Wert ist außerhalb eines vorgegebenen Bereichs, in welchem Fall eine weitere Umlaufberechnung ausgeführt wird, um den berechneten Wert in einen Wert innerhalb des Bereichs umzuwandeln, wobei C eine vorbestimmte Konstante ist, welche in Übereinstimmung mit der gewünschten Meßauflösung ausgewählt ist, $K_f$ der Wert von K ist, welcher in der genannten Meßeinrichtung (110) resultiert, wenn diese kein Ausgangssignal produziert, $P_f$ die Polarität des Integrationsresultates des ersten Demodulationssignals für das Paar von Anregungssignalgruppen ist, welche die genannte Meßeinrichtung veranlaßt, kein Ausgangssignal zu erzeugen, und $T_f$ die Zeit ist, welche erforderlich für die Integration des zweiten Demodulationssignals (440) für das Paar von Anregungsgruppen ist, welches veranlaßt, daß die Meßeinrichtung kein Ausgangssignal erzeugt.

2. Verfahren nach Anspruch 1, worin der Anfangswert für K des Teils des Meßzyklus, welcher $M_m$ erzeugt, gemäß der Formel $K = M_c - N{*}Int(M_c/N)$ ausgewählt wird; und der Anfangswert für K für den Teil des Meßzyklus, welcher $M_f$ erzeugt, gemäß der Formel $K = M_m - N{*}Int(M_m/N)$ ausgewählt wird.

3. Verfahren nach Anspruch 2, worin der Wert $M_c$ während des Teil des Meßzyklus zum Erzeugen von $M_m$ gemäß dem Wert des zugeordneten Integrationsergebnisses des ersten Demodulationssignals, jedes Mal wenn die Meßeinrichtung ein Ausgangssignal erzeugt, erhöht oder erniedrigt wird.

**4.** Verfahren nach Anspruch 3, worin der Wert $M_m$ während des Teils des Meßzyklus, welcher $M_f$ erzeugt, gemäß dem Wert des Integrationsergebnisses des zugeordneten ersten Demodulationssignals, jedes Mal wenn die genannte Meßeinrichtung ein Ausgangssignal produziert, erhöht oder erniedrigt wird; und wenn der so erhöhte oder erniedrigte Wert von $M_m$ außerhalb des vorbestimmten Bereichs für $M_m$ ist, der Wert von $M_c$ entsprechend auf einen neuen Wert eingestellt wird.

**5.** Verfahren nach Anspruch 4, worin der $M_f$ Wert und die $M_m$ und $M_c$ Werte, welche als ein Ergebnis des Erzeugens des $M_f$ Wertes erhalten werden, bezüglich einander in Übereinstimmung mit dem relativen dimensionalen Meßwert gewichtet werden, welcher durch jede Erhöhung des Skalenpositionswertes repräsentiert wird, und die gewichteten Skalenpositionswerte summiert werden, um daraus den ge − nannten absoluten Positionsmeßwert ($M_p$) abzuleiten.

**Revendications**

**1.** Procédé de mesure absolue de positions dans un appareil de mesure du type capacitif comprenant :

des premier et deuxième organes de support (20,30), lesdits organes de support étant déplaçables relativement l'un par rapport à l'autre, et au moins un desdits organes de support étant déplaçable relativement à un axe de mesure (X);

les moyens à rangées d'électrodes (210A,210B,220A,220B,310,320A,320B) disposés sur lesdits premier et deuxième organes de support (20,30) en alignement relatif avec ledit axe de mesure (X) pour fournir une pluralité de trajets de transmission de signaux discrets ayant chacun une fonction de transfert capacitive qui varie en fonction des positions relatives desdits premier et deuxième organes de support (20,30) l'un par rapport à l'autre; ladite fonction de transfert capacitive ayant une première composante qui varie sur une première longueur d'onde prédéterminée selon la position du trajet de transmission associé relativement à une position de référence sur un des organes de support, et une deuxième composante qui varie selon une fonction prédéterminée du déplacement entre lesdits premier et deuxième organes de support sur une deuxième longueur d'onde prédéterminée plus courte que ladite première longueur d'onde prédéterminée;

lesdits moyens à rangées d'électrodes comprenant :

une rangée d'électrodes émettrices (310) ayant au moins un groupe de N électrodes émettrices (312) adjacentes, espacées les unes des autres relativement à l'axe de mesure (X), dans laquelle N a une valeur qui est un multiple entier de quatre;

une rangée de premières électrodes réceptrices (210A,210B) disposée sur ledit deuxième organe de support (20) en alignement avec ledit axe de mesure (X) et telle que des portions différentes de ladite rangée de premières électrodes réceptrices (210A,210B) sont couplées capacitivement à ladite rangée d'électrodes émettrices (310) en fonction des positions relatives desdits organes de support (20,30);

lesdites premières électrodes réceptrices (212A,212B) étant espacées les unes des autres relati − vement à l'axe de mesure par un pas $P_{r1}$ définissant une longueur d'onde d'échelle $W_f$,

ledit au moins un groupe d'électrodes émettrices (312) définissant une longueur d'onde d'émission $W_t$, et

les électrodes émettrices (312) dans chaque groupe étant positionnées à l'intérieur du groupe de manière à occuper respectivement des positions de groupe prédéterminées qui recouvrent une distance supérieure à une longueur d'onde $W_f$, et telles que chaque position de groupe correspond à la position relative parmi différentes positions d'un groupe de positions relatives de segments de longueur d'onde fine ($W_f$), obtenues en divisant la longueur d'onde d'émission $W_t$ en intervalles correspondant à la longueur d'onde fine et en divisant chaque intervalle en N segments égaux; et

des moyens à électrodes détectrices pour produire des premières et deuxièmes sorties en réponse à des signaux d'excitation appliqués à ladite rangée d'électrodes émettrices, lesdites sorties des électrodes détectrices variant individuellement en accord avec ladite première composante de la fonction de transfert et produisant, lorsqu'elles sont combinées, un signal qui varie en accord avec ladite deuxième composante de la fonction de transfert;

des moyens de génération de signaux d'excitation (120) pour générer sélectivement des groupes de N signaux d'excitation (400) pour leur application aux N électrodes respectives dudit au moins un groupe d'électrodes émettrices (312) dans un ordre choisi parmi un premier ordre spatial et un deuxième ordre spatial;

ledit premier ordre spatial étant défini par un premier ordre de connexion selon la séquence de positions des électrodes émettrices (312) relatives les unes aux autres dans ledit au moins un groupe d'électrodes émettrices, et ledit deuxième ordre spatial étant défini par un deuxième ordre de connexion selon la séquence de positions relatives de segments de longueur d'onde fine selon laquelle les positions respectives du groupe d'électrodes émettrices sont arrangées;

chacun desdits groupes de signaux d'excitation (400) comprenant deux jeux de signaux d'excitation qui sont inversés en phase l'un par rapport à l'autre et en quadrature de phase spatiale lorsqu'ils sont appliqués auxdites électrodes émettrices (312), dans lesquels les positions relatives de phase spatiale occupées par les jeux respectifs de signaux d'excitation (400) dans chaque groupe de signaux d'excitation changent de façon incrémentale successivement d'un groupe au suivant;

des moyens de commande (110) pour commander lesdits moyens de génération de signaux d'excitation (120) pour appliquer sélectivement une paire de premier et deuxième groupes parmi lesdits groupes de signaux d'excitation audit au moins un groupe d'électrodes émettrices (312);

des moyens de sélection de signal de sortie (130) pour choisir un signal correspondant auxdites premières et deuxièmes sorties (410,420) des électrodes détectrices ou audit signal de sortie combiné des électrodes détectrices en tant que signal de sortie (430) des moyens à rangées d'électrodes, et pour produire par ce moyen des premier et deuxième signaux de sortie successifs des moyens à rangées d'électrodes en réponse à ladite paire de groupes de signaux d'excitation;

des moyens (142) pour démoduler lesdits premiers et deuxièmes signaux de sortie (410,420) pour produire des premier et deuxième signaux de démodulation (440), et des moyens (144) pour effectuer une intégration à pente double desdits premier et deuxième signaux de démodulation (440) dans laquelle ledit premier signal de démodulation est intégré pendant un intervalle de temps prédéterminé ($T_o$) par lesdits moyens d'intégration (144) et ledit deuxième signal de démodulation est intégré par lesdits moyens d'intégration (144) jusqu'à ce que la sortie des moyens d'intégration retourne à un niveau de référence, lesdits premier et deuxième desdits groupes de signaux d'excitation étant choisis de telle sorte que ladite intégration dudit deuxième signal de démodulation cause l'intégration de la sortie des moyens d'intégration dans le sens inverse de ladite intégration de la sortie dudit premier signal de démodulation;

des moyens de mesure (146) pour mesurer le temps d'intégration (T) de ladite intégration du deuxième signal démodulé et pour produire une sortie lorsque le temps d'intégration excède une valeur limite ($T_{max}$) prédéterminée;

lesdits moyens de commande (110) étant sensibles à ladite sortie des dits moyens de mesure (146) du temps d'intégration pour remettre à zéro lesdits moyens de démodulation (142) et d'intégration à pente double (144), pour appliquer sélectivement et répétitivement une paire supplémentaire différente de premier et deuxième groupes desdits groupes de signaux d'excitation (400) audit au moins un groupe (310) d'électrodes émettrices, et pour causer l'intégration desdits premier et deuxième signaux de démodulation (440) résultants par lesdits moyens de démodulation et d'intégration à pente double, jusqu'à ce qu'il n'y ait pas de sortie desdits moyens de mesure (146) du temps d'intégration;

lesdits moyens de commande (110) produisant une valeur de position d'échelle lorsque lesdits moyens de mesure (146) du temps d'intégration ne produisent pas de sortie;

lesdits moyens de commande (110) incluant une boucle de commande principale pour commander lesdits moyens de génération de signaux d'excitation (120) et lesdits moyens de sélection de signal de sortie (130) de manière à effectuer un cycle de mesure pour produire successivement :

une première valeur de position d'échelle, $M_c$, à partir d'un deuxième signal de démodulation (440) produit à partir d'un deuxième signal de sortie des moyens à rangées d'électrodes correspondant auxdites premières et deuxièmes sorties (410,420) des électrodes détectrices, produites en réponse à un groupe de signaux d'excitation (400) généré dans ledit premier ordre spatial;

une deuxième valeur de position d'échelle, $M_m$, à partir d'un deuxième signal de démodulation (440) produit à partir d'un deuxième signal de sortie des moyens à rangées d'électrodes correspondant audit signal de sortie combiné des électrodes détectrices, produit en réponse à un groupe de signaux d'excitation (400) généré dans ledit premier ordre spatial; et

une troisième valeur de position d'échelle, $M_f$, à partir d'un deuxième signal de démodulation (440) produit à partir d'un deuxième signal de sortie des moyens à rangées d'électrodes correspondant auxdites premières et deuxièmes sorties des électrodes détectrices, produites en réponse à un groupe de signaux d'excitation (400) généré dans ledit deuxième ordre spatial;

et pour combiner lesdites première, deuxième et troisième valeurs de position d'échelle pour produire une mesure de position absolue ($M_p$);

23

ledit procédé étant caractérisé en ce que :

à chaque groupe de N signaux d'excitation (400) est affectée une valeur K, où K est compris entre 1 et N et au début de chaque portion du cycle de mesure pour générer des paires successives de groupes de signaux d'excitation pour la production d'une valeur de position d'échelle, le premier desdits groupes de signaux d'excitation dans la paire initiale de groupes de signaux d'excitation est choisi selon une valeur initiale prédéterminée de K et par la suite, la valeur de K est incrémentée ou décrémentée en accord avec la polarité du résultat de l'intégration du premier signal de démodulation, pour produire une nouvelle valeur de K pour choisir le premier groupe suivant desdits groupes de signaux d'excitation (400) dans la paire supplémentaire suivante de groupes de signaux d'excitation;

ladite valeur de position d'échelle $M_c$ est calculée selon la formule $M_c = A*K_c + P_c*T_c$, à moins que la valeur ainsi calculée soit à l'extérieur d'un domaine prédéterminé, auquel cas un calcul supplémentaire par enroulement est effectué pour convertir la valeur calculée en une valeur à l'intérieur du domaine, où A est une constante prédéterminée choisie selon la relation entre les longueurs d'onde $W_c$ et $W_m$, $K_c$ est la valeur de K qui a eu pour conséquence que lesdits moyens de mesure (110) n'ont pas produit de sortie durant la portion du cycle de mesure pour la production de ladite valeur $M_c$, $P_c$ est la polarité du résultat de l'intégration du premier signal de démodulation pour laquelle la paire supplémentaire suivante de groupes de signaux d'excitation ne cause la production d'aucune sortie par lesdits moyens de mesure, et $T_c$ est le temps requis pour l'intégration du deuxième signal de démodulation (440) pour laquelle la paire de groupes d'excitation ne cause la production d'aucune sortie par lesdits moyens de mesure;

ladite valeur de position d'échelle $M_m$ est calculée selon la formule $M_m = B*K_m + P_m*T_m$, à moins que la valeur ainsi calculée soit à l'extérieur d'un domaine prédéterminé, auquel cas un calcul supplémentaire par enroulement est effectué pour convertir la valeur calculée en une valeur à l'intérieur du domaine, où B est une constante prédéterminée choisie selon la relation entre les longueurs d'onde $W_m$ et $W_f$, $K_m$ est la valeur de K qui a eu pour conséquence que lesdits moyens de mesure n'ont pas produit de sortie durant la portion du cycle de mesure pour la production de ladite valeur $M_m$, $P_m$ est la polarité du résultat de l'intégration du premier signal de démodulation pour laquelle la paire de groupes de signaux d'excitation ne cause la production d'aucune sortie par lesdits moyens de mesure, et $T_m$ est le temps requis pour l'intégration du deuxième signal de démodulation (440) pour laquelle la paire de groupes d'excitation ne cause la production d'aucune sortie par lesdits moyens de mesure;

ladite valeur de position d'échelle $M_f$ est calculée selon la formule $M_f = C*K_f + P_f*T_f$, à moins que la valeur ainsi calculée soit à l'extérieur d'un domaine prédéterminé, auquel cas un calcul supplémen − taire par enroulement est effectué pour convertir la valeur calculée en une valeur à l'intérieur du domaine, où C est une constante prédéterminée choisie selon la résolution désirée pour la mesure, $K_f$ est la valeur de K qui a eu pour conséquence que lesdits moyens de mesure n'ont pas produit de sortie, $P_f$ est la polarité du résultat de l'intégration du premier signal de démodulation pour laquelle la paire de groupes de signaux d'excitation ne cause la production d'aucune sortie par lesdits moyens de mesure, et $T_f$ est le temps requis pour l'intégration du deuxième signal de démodulation (440) pour laquelle la paire de groupes d'excitation ne cause la production d'aucune sortie par lesdits moyens de mesure.

2. Procédé selon la revendication 1, dans lequel la valeur initiale de K pour la portion du cycle de mesure pour la production de $M_m$ est choisie selon la formule $K = M_c − N*Int(M_c/N)$; et la valeur initiale de K pour la portion du cycle de mesure pour la production de $M_f$ est choisie selon la formule $K = M_m − N*Int(M_m/N)$.

3. Procédé selon la revendication 2, dans lequel la valeur de $M_c$ est incrémentée ou décrémentée durant la portion du cycle de mesure pour la production de $M_m$ selon la valeur du résultat de l'intégration du premier signal de démodulation associé chaque fois que lesdits moyens de mesure produisent une sortie.

4. Procédé selon la revendication 3, dans lequel la valeur de $M_m$ est incrémentée ou décrémentée durant la portion du cycle de mesure pour la production de $M_f$ selon la valeur du résultat de l'intégration du premier signal de démodulation associé chaque fois que lesdits moyens de mesure produisent une sortie; et si la valeur de $M_m$ ainsi incrémentée ou décrémentée est à l'extérieur du domaine prédéterminé pour $M_m$, la valeur de $M_c$ est ajustée en conséquence à une nouvelle valeur.

**5.** Procédé selon la revendication 4, dans lequel la valeur $M_f$, et les valeurs $M_m$ et $M_c$ ainsi obtenues en conséquence de la production de la valeur $M_f$, sont pondérées les unes par rapport aux autres en accord avec la valeur dimensionnelle relative de la mesure représentée par chaque incrément des valeurs de position d'échelle, et les valeurs de position d'échelle pondérées sont additionnées pour déduire ladite mesure de position absolue ($M_p$).

Fig. 1

Fig. 2A

Fig. 2B

Fig. 3

Fig. 4

Fig. 5

EP 0 404 980 B1

## Fig. 6

ROM I

| | CONTROL SIGNAL 112 | | | | 127-1 | 127-2 | 127-3 | 127-4 | 127-5 | 127-6 | 127-7 | 127-8 |
|---|---|---|---|---|---|---|---|---|---|---|---|---|
| K | U | V | W | F/MC | | | | | | | | |
| 1 | O | O | O | O | O | O | O | O | I | I | I | I |
| 2 | O | O | I | O | I | O | O | O | O | I | I | I |
| 3 | O | I | O | O | I | I | O | O | O | O | I | I |
| 4 | O | I | I | O | I | I | I | O | O | O | O | I |
| 5 | I | O | O | O | I | I | I | I | O | O | O | O |
| 6 | I | O | I | O | O | I | I | I | I | O | O | O |
| 7 | I | I | O | O | O | O | I | I | I | I | O | O |
| 8 | I | I | I | O | O | O | O | I | I | I | I | O |
| 1 | O | O | O | I | O | I | O | I | I | O | I | O |
| 2 | O | O | I | I | I | I | O | I | O | O | I | O |
| 3 | O | I | O | I | I | O | O | I | O | I | I | O |
| 4 | O | I | I | I | I | O | I | I | O | I | O | O |
| 5 | I | O | O | I | I | O | I | O | O | I | O | I |
| 6 | I | O | I | I | O | O | I | O | I | I | O | I |
| 7 | I | I | O | I | O | I | I | O | I | O | O | I |
| 8 | I | I | I | I | O | I | O | O | I | O | I | I |

GROUP PHASE COMBINATIONS — COARSE / MEDIUM — FINE

### SWITCH CONTROL SIGNALS 133

| ROM CONTROL SIGNAL 113 | S11 | S12 | S13 | S14 | S21 | S22 | S23 | S24 | S25 | S26 |
|---|---|---|---|---|---|---|---|---|---|---|
| (FINE) 11 | I | I | I | I | O | O | I | I | O | O |
| (MEDIUM) 01 | O | O | I | I | I | I | I | O | I | O |
| (COARSE) 10 | I | I | O | O | O | I | O | I | I | I |

## Fig. 7

START — S1000

S1200
COARSE MODE
SUBPROGRAM
(Fig. 8B)

S1300
MEDIUM MODE
SUBPROGRAM
(Fig. 8C)

S1400
FINE MODE
SUBPROGRAM
(Fig. 8D)

S1500
CONVERT SCALE
POSITION VALUE
TO MEASUREMENT
POSITION VALUE

S1600
OUTPUT
PROCESSING
FOR DISPLAY

MASTER MEASUREMENT PROGRAM

Fig. 8A

## Fig. 8B

### COARSE MODE SUBPROGRAM

S1210
SET TRANSDUCER
OUTPUT SIGNAL
COMBINER 130
TO COARSE MEAS.
MODE
SIGNAL 430=A-B

S1220
$K = K_c$

S1230
GENERATE $K^{TH}$
COARSE MODE
GROUP PHASE
COMBINATION OF
EXCITATION
SIGNALS 400

S1240
ADC
SUBPROGRAM
(Fig. 8E)

S1250
$T > T_{max}$

YES

S1260
$K = K + P$

NO S1270
$K_c = K$

S1280
CALCULATE
COARSE SCALE
POSITION VALUE
$M_c$

TO
SUBPROGRAM MEDIUM
(STEP 1300)

34

EP 0 404 980 B1

## Fig. 8C
### MEDIUM MODE SUBPROGRAM

SET TRANSDUCER OUTPUT SIGNAL COMBINER 130 TO MED. MEAS. MODE SIGNAL 430=C-D ⟵ S1310

$K = M_c - N * int\left(\dfrac{M_c}{N}\right)$ ⟵ S1320

S1330 ⟶ GENERATE K$^{TH}$ MED. MODE GROUP PHASE COMBINATION OF EXCITATION SIGNALS 400

S1360 ⟶ $M_c = M_c + P$

S1340 ⟶ ADC SUBPROGRAM (Fig. 8E)

S1350 ⟶ $T > T_{max}$ — YES

NO

S1370 ⟶ $K_m = K$

S1380 ⟶ CALCULATE MED SCALE POSITION VALUE $M_m$

TO SUBPROGRAM FINE (STEP S1400)

35

## Fig. 8D

### FINE MODE SUBPROGRAM

SET TRANSDUCER OUTPUT SIGNAL COMBINER 130 TO FINE MEAS. MODE SIGNAL 430 = (A+B) - (C+D) — S1410

$K = M_m - N * Int \left( \dfrac{M_m}{N} \right)$ — S1420

GENERATE $K^{TH}$ FINE MODE GROUP PHASE COMBINATION OF EXCITATION SIGNALS 400 — S1430

ADC SUBPROGRAM (Fig. 8E) — S1440

$T > T_{max}$ — S1450

NO — $K_F = K$ — S1470

CALCULATE FINE SCALE POSITION VALUE $M_F$ — S1480

TO STEP 1500

YES — $M_m = M_m + P$ — S1460

$M_m$ WRAP-AROUND — S1462

YES — ADJUST $M_c$ — S1464

36

## Fig. 8E
### ADC SUBPROGRAM

RESET
INTEGRATOR
144
— S1710

INTEGRATE
DEMODULATED
RESULTANT
OUTPUT SIGNAL
440 OVER $T_0$
— S1720

S1730

SENSE POLARITY
OF INTEGRATOR
OUTPUT 450

⊕    ⊖

S1740 — P=1     S1750 — P=-1

S1760

GENERATE
K = K + 2P
GROUP PHASE
COMBINATION OF
EXCITATION
SIGNALS  400

S1770

INTEGRATE
SIGNAL 440
UNTIL SIGNAL
450=0; MEAS.
INTEG. TIME T

END

Fig. 9

GROUP PHASE EXCITATION SIGNAL COMBINATIONS